# EUROPÄISCHE PATENTSCHRIFT

(11) **EP 4 199 064 B1**
(45) Veröffentlichungstag und Bekanntmachung des Hinweises auf die Patenterteilung: **25.06.2025**
(21) Anmeldenummer: 21215189.8
(22) Anmeldetag: 16.12.2021
(51) Int. Cl.: H10D 84/01, H10D 84/03, H10D 84/60, H10D 10/80, H10D 62/17, H10D 10/01, H10D 84/40

(54) **VERFAHREN ZUR HERSTELLUNG VON BIPOLARTRANSISTOREN MIT NICHTSELEKTIVER BASISEPITAXIE**
METHOD FOR THE PREPARATION OF BIPOLAR TRANSISTORS BY MEANS OF NON-SELECTIVE BASE EPITAXY
PROCÉDÉ DE FABRICATION DE TRANSISTORS BIPOLAIRES À ÉPITAXIE DE BASE NON SÉLECTIVE

(43) Veröffentlichungstag der Anmeldung: 21.06.2023
(73) Patentinhaber: IHP GmbH - Leibniz Institute for High Performance Microelectronics/ Leibniz-Institut für innovative Mikroelektronik, 15236 Frankfurt (Oder) (DE)
(72) Erfinder: Heinemann, Bernd, 15236 Frankfurt (Oder) (DE); Rücker, Holger, 15236 Frankfurt (Oder) (DE)
(74) Vertreter: Eisenführ Speiser

(56) Entgegenhaltungen:
- WO-A1-2010/066630
- DE-B4- 10 358 046
- US-A1- 2017 179 220
- US-A1- 2017 365 695
- US-A1- 2019 035 919
- US-A1- 2019 140 072
- US-B1- 10 186 605

## Beschreibung

### TECHNISCHES GEBIET

Die Erfindung bezieht sich auf Verfahren zur Herstellung von Bipolartransistoren in einem BiCMOS-Herstellungsprozess. Die Verfahren betreffen insbesondere die Ermöglichung einer wahlweise alternativen oder gemeinsamen Herstellung von unterschiedlichen Typen von Bipolartransistoren für Hochgeschwindigkeitsanwendungen und für Hochspannungsanwendungen im Rahmen eines BiCMOS-Herstellungsprozesses. Die Erfindung betrifft darüber hinaus eine BiCMOS-Halbleitervorrichtung.

### STAND DER TECHNIK

Bipolartransistoren werden in vielfältiger Weise in integrierten analogen und digitalen elektronischen Schaltungen eingesetzt. Insbesondere werden Bipolartransistoren wegen ihrer kurzen Schaltzeiten für Hochgeschwindigkeitsanwendungen genutzt. Die Leistungsfähigkeit von Bipolartransistoren im Hochgeschwindigkeitsbereich konnte durch eine vertikale und laterale Skalierung der Transistordimensionen und durch die Einführung epitaktisch hergestellter Basisschichten erheblich gesteigert werden.

Dazu hat insbesondere die Entwicklung von Heterobipolartransistoren (HBT) beigetragen. Bei Heterobipolartransistoren bestehen die Emitter- und Basisschicht aus unterschiedlichen Halbleitermaterialien, wobei der Emitter eine größere Bandlücke besitzt als die Basis.

Ein Beispiel dafür sind SiGe-Heterobipolartransistoren, bei denen der Emitter aus Silizium (Si) besteht und die Basis eine Silizium-Germanium-Legierung (SiGe) enthält.

Ob die Hochfrequenzeigenschaften moderner SiGe-HBTs weiter verbessert werden können hängt davon ab, wie es gelingt, das Potenzial lateraler und vertikaler Skalierung auszunutzen, um innere Transit- und Ladezeiten sowie äußere parasitäre Effekte, wie den äußeren Basiswiderstand, die Widerstände von Emitter und Kollektor oder die externen Basis-Emitter- und Basis-Kollektor-Kapazitäten zu minimieren.

Es werden unterschiedliche Ansätze für die Herstellung von SiGe-HBTs im Hochgeschwindigkeitsbereich verfolgt. Die Art der Basisepitaxie hat erhebliche Auswirkungen auf die Gestaltung des Herstellungsprozesses. Als besonders attraktiv hat sich die sogenannte Doppel-Polysilizium-Technologie mit selektiver Basisepitaxie erwiesen, weil damit bei moderatem Aufwand Transistoren hergestellt werden können, die in wesentlichen Teilen, nämlich externer Basisanschluss zu Emitter und Emitter zu Kollektor, selbstjustiert sind. In der Technologiegruppe mit differentieller (nichtselektiver) Basis-Epitaxie (NSEG) (engl. non-selective epitaxial growth), findet man neben selbst- auch nicht-selbstjustierte Basis-Emitter-Anordnungen. Um die vertikale Ausdehnung der externen Basisschicht von den Dickenanforderungen der inneren Basisschicht sowie der darüber liegenden undotierten Deckschicht (Cap-Schicht) zu entkoppeln, haben sich für NSEG-Technologien Verfahren mit Verstärkung des Basisanschlussgebietes etabliert. Eine weitere Abgrenzungsmöglichkeit der Prozesse zur Fertigung von Hochgeschwindigkeits-HBTs betrifft die Art der lateralen Isolation der hochdotierten Kollektorschicht. Im Allgemeinen werden epitaktisch vergrabene, hochleitfähige Gebiete eingebracht, die seitlich durch tiefe, ganz oder teilweise mit Isolatormaterial gefüllte Gräben (engl. Deep Trenches (DT)) vom Substrat getrennt sind. Die Herstellung der gegenwärtig schnellsten SiGe HBTs kommt ohne das Konstruktionsmerkmal "DT-isolierter, epitaktisch vergrabener Sub-Kollektor" aus. Hierbei wird die laterale Isolation einer relativ flachen, hochdotierten Kollektorschicht zum Substrat von STI-Gebieten übernommen und für die dielektrische Isolation der externen Basisschicht eine Isolatorschicht oberhalb der Substratoberfläche eingesetzt. Zum Stand der Technik gehört im Zusammenhang mit Verfahren zur Realisierung von Hochgeschwindigkeits-(HS, engl. High-Speed)-SiGe-HBTs und deren Integration in CMOS-Technologien auch die Bereitstellung von Bipolartransistoren mit höheren Emitter-Kollektor- bzw. Kollektor-Basis-Durchbruchsspannungen (HV-Transistoren). Meist werden dafür weitgehend die Herstellungsschritte der HS-Transistoren übernommen. Aufmerksamkeit ist bei der Anfertigung der HV-Transistoren darauf zu richten, auf welche Art und Weise höhere Kollektordotierungen in Basisnähe eliminiert und durch geeignete schwache Konzentrationen ersetzt werden.

In DE 10358046 wird ein Bipolartransistor mit nichtselektiv abgeschiedener Basisschicht und ein Verfahren zu seiner Herstellung beschrieben, bei dem sich das innere Transistorgebiet gemeinsam mit dem Kollektoranschluss- und -kontaktgebiet in einem einfach zusammenhängenden Aktiv-Gebiet der Substratscheibe befindet und zu dem ein dielektrisch isolierter, epitaktisch verstärkter Basisanschluss gehört, der selbstjustierend durch Spacer vom Emitter getrennt ist.

Spezielles Augenmerk wird dabei auf die Formgebung der elektrisch isolierenden Basis-Emitter-Spacer gelegt. Diese Konstruktion erlaubt mit Hilfe geeigneter Dotierungsverfahren der verstärkten Basisanschlussschicht eine kapazitätsarme Reduktion des Basiswiderstandes, wodurch die Grenzfrequenz der Leistungsverstärkung gesteigert wird. Diese Grenzfrequenz wird als fₘₐₓ bezeichnet. Darüber hinaus führt eine Reduktion des Basiswiderstandes zu einer Verbesserung der Rauscheigenschaften des Transistors. Im Zusammenhang mit der in DE 10358046 beschriebenen Transistorkonstruktion und seiner Herstellung wird in Rücker, H., et.al.:"A 0.13 µm SiGe BiCMOS Technology featuring fT/fmax of 240/330 GHz and gate delays below 3 ps", IEEE Journal of Solid State Circuits, vol. 45, pp. 1678-1686, Sept. 2010, neben der Fertigung eines high-speed SiGe (HS) HBTs über die Fabrikation eines sogenannten Hochspannungs- oder "High-Voltage (HV) Transistor" berichtet, bei der Lithographiemasken sparend für die Kollektordotierung tieferliegende n-Wannen der CMOS-Anordnungen und Shallow-Trench-Isolation (STI) für die laterale Separation von innerem Transistor und Kollektoranschluss genutzt werden.

Der im Stand der Technik dargelegte Weg zur Verbesserung der Hochgeschwindigkeitseigenschaften eines SiGe-HBTs bei gleichzeitiger, Fertigungskosten sparender Realisierung eines HV-Bipolartransistors bot erhebliches Potential für Emitterweiten bis hinunter zu etwa 180 nm. Weitere Geschwindigkeitsfortschritte durch laterale und vertikale Verkleinerung sind mit den bei Rücker et.al. eingesetzten Mitteln kaum zu erreichen. Das nasschemische Ätzverhalten von LPCVD-Oxid- (TEOS) Beschichtungen führt zu einer erheblichen Aufweitung des durch die Trocken-Ätzung definierten Maßes der Emitter- und Kollektorfenster der HS-HBTs. Zum anderen stellt die im Stand der Technik gegebene Möglichkeit, auf Veränderungen der Spacer-Bildung bei verringerter Stufenhöhe zwischen der Emitter-Poly-Schicht und dem verstärkten Basisanschlussgebiet zu reagieren, den Device-Ingenieur vor Probleme. Unbefriedigend ist beim hier ausgeführten Stand der Technik auch die fehlende Möglichkeit, die Seitenwand einer Isolationsschicht derart zu gestalten, dass bei nachfolgender Si-Epitaxie die Bildung von Facetten im gewachsenen Si vermieden und die Ausprägung kapazitäts- und widerstandsarmer Formen des seitlich angrenzenden Isolationsgebietes gefördert werden. Des Weiteren führt die kollektorseitige Ausgestaltung des HV-Transistors mit unter dem STI verlaufenden Kollektoranschlussgebieten zu Nachteilen in den Hochfrequenzeigenschaften. Vorteilhaft würden sich eine hochleitfähige Kollektorschicht, die die Basis-Kollektor-Raumladungszone und den Kollektorkontakt verbindet, und eine kapazitätsärmere Gestaltung der Kollektor-Substart-Diode auswirken.

WO 2010/066630 A1 beschreibt ein Halbleiterbauelement mit einer Substratschicht aus einem Halbleitermaterial eines ersten Leitfähigkeitstyps mit einem ersten Isolationsbereich und einem vertikalen Bipolartransistor mit einem ersten Höhenabschnitt eines Kollektors aus monokristallinem Halbleitermaterial eines zweiten Leitfähigkeitstyps, der in einer Öffnung des ersten Isolationsbereichs angeordnet ist, einem zweiten Isolationsbereich, der teilweise auf dem ersten Höhenabschnitt des Kollektors und teilweise auf dem ersten Isolationsbereich liegt und eine Öffnung im Bereich des Kollektors aufweist, in der ein zweiter Höhenabschnitt des Kollektors aus monokristallinem Material angeordnet ist, umfassend einen inneren Bereich des zweiten Leitfähigkeitstyps, eine Basis aus monokristallinem Halbleitermaterial des ersten Leitfähigkeitstyps, einen Basisanschlussbereich, der von der Basis in seitlicher Richtung umgeben ist, einen T-förmigen Emitter aus Halbleitermaterial des zweiten Leitfähigkeitstyps, der den Basisanschlussbereich überlappt, wobei der Basisanschlussbereich aus einem Halbleitermaterial besteht, das sich in seiner chemischen Zusammensetzung vom Halbleitermaterial des Kollektors, der Basis und des Emitters unterscheidet, mit Ausnahme einer Keimschicht, die an das Substrat grenzt, oder einer Metallisierungsschicht, die an den Kontakt mit der Basis grenzt, und eine größere Beweglichkeit von Majoritätsladungsträgern des ersten Leitfähigkeitstyps im Vergleich dazu aufweist.

US 2019/0140072 A1 beschreibt einen Bipolartransistor, der von einem einkristallinen Siliziumsubstrat mit einem Kollektoranschlussbereich getragen wird. Ein erster Epitaxiebereich bildet einen Kollektorbereich, der mit einem ersten Leitfähigkeitstyp auf dem Kollektoranschlussbereich dotiert ist. Der Kollektorbereich enthält einen gegendotierten Bereich eines zweiten Leitfähigkeitstyps. Ein zweiter Epitaxiebereich bildet einen Basisbereich eines zweiten Leitfähigkeitstyps auf dem ersten Epitaxiebereich. Abgeschiedenes Halbleitermaterial bildet einen Emitterbereich des ersten Leitfähigkeitstyps auf der zweiten Epitaxiezone. Die Kollektorzone, Basiszone und Emitterzone befinden sich in einer Öffnung, die in einem Stapel von Isolierschichten mit einer Opferschicht ausgebildet ist. Die Opferschicht wird selektiv entfernt, um eine Seitenwand der Basiszone freizulegen. Epitaktisches Wachstum von der freigelegten Seitenwand bildet eine Basiskontaktzone.

### BESCHREIBUNG DER ERFINDUNG

Gegenüber dem bekannten Stand der Technik stellt sich daher das technische Problem, Verfahren zur Herstellung eines weiter lateral skalierten Bipolartransistors einschließlich einer zweiten Ausführung eines Bipolartransistors mit einer höheren Basis-Kollektor- bzw. Kollektor-Emitter-Durchbruchsspannung bereitzustellen. Diese sollen die Hochfrequenztauglichkeit der Bipolartransistoren mit Hilfe kleinerer lateraler und vertikaler Dimensionen verbessern und eine ausreichende Fertigungssicherheit im Hinblick auf Toleranzen und die funktionelle Ausbeute (yield) sicherstellen.

Darüber hinaus sind Herstellungsverfahren gesucht, die den gewünschten Schutz des T-förmigen Emitters weitgehend unabhängig von seiner Höhe und Form während einer Implantation oder der selektiven Verstärkung des Basisanschlussgebietes gewährleisten.

Dieses Problem wird gemäß einem ersten Aspekt der Erfindung durch ein Verfahren zur Herstellung von Hochgeschwindigkeitsbipolartransistoren im Rahmen der Durchführung eines BiCMOS-Herstellungsprozesses gelöst, welches im Anspruch 1 definiert ist. Weiterhin wird das Problem gelöst durch eine BiCMOS-Halbleitervorrichtung umfassend Hochgeschwindigkeitsbipolartransistoren (HS-Transistoren), und Hochspannungs-Bipolartransistoren (HV-Transistoren) mit den Merkmalen des Anspruchs 14.

Bei dem erfindungsgemäßen Verfahren werden im Rahmen einer BiCMOS-Technologie neben HS-Transistoren, also Bipolartransistoren mit besonders hohen Grenzfrequenzen f_{T} und fₘₐₓ, auch HV-Transistoren, also Bipolartransistoren mit höherer Durchbruchsspannung gefertigt.

Die Erfindung verbessert verschiedene Aspekte der im Stand der Technik beschriebenen Vorrichtung von HS- und HV-Bipolartransistoren und deren Herstellung. Ausführungsbeispiele des Verfahrens der vorliegenden Erfindung überwinden Herstellungsnachteile einer eingangs beschriebenen, bekannten Technologie, welche Bipolartransistoren mit nichtselektiver Basisabscheidung herstellt, deren Kollektorgebiet seitlich von flachen Feldisolationsgebieten umschlossen ist und die über eine selbstjustierte Basis-Emitter-Anordnung sowie epitaktisch verstärkte Basisanschlussgebiete verfügen.

Zum einen wird die aus dem Stand der Technik bekannte Anordnung des HV-Transistors mit einem zusätzlichen flachen, in STI-Technik gefertigten Feldisolationsgebiet, das zwischen dem innerem Transistorgebiet und dem Kollektorkontakt angeordnet ist, abgelöst durch eine Konstruktion, die im Querschnittsbild der des High-Speed Transistors entspricht. Mit anderen Worten, in den für die HV-Transistoren vorgesehenen aktiven Gebieten gibt es jeweils nur ein zusammenhängendes hochleitfähiges HV-Kollektorgebiet eines ersten Leitfähigkeitstyps. Das für diesen Transistor benötigte, spezielle Basis-Kollektor-Dotierungsprofil wird mit Hilfe einer extra Prozessfolge zur Öffnung und Implantation der HV-Kollektorgebiete eingebracht.

Als wesentliche Vorteile dieser Verfahrensführung im Vergleich zur eingangs beschriebenen bekannten Lösung sind eine weiter verbesserte Vermeidung von Leckstrom am seitlichen Basis-Kollektor-Übergang sowie eine Reduktion des Kollektorwiderstandes, der Basis-Kollektor-Kapazität und der Kollektor-Substrat-Kapazität zu nennen. Damit werden sowohl die Hochspannungsfestigkeit als auch Hochfrequenzeigenschaften verbessert.

Vorteile erzielt das Verfahren der Erfindung auch mit einer Ersetzung einzelner Siliziumdioxid-Schichten durch Schichtkombinationen mehrerer Isolatorschichten im Schritt c und im Schritt g. Im Einzelnen betrifft das (Schritt c) die im Stand der Technik eingesetzte Siliziumoxid-Schicht zwischen dem externem Basisanschlussgebiet und dem Kollektoranschlussgebiet sowie (Schritt g) diejenige, aus welcher der Basis-Emitter-Spacer geformt wird. Insbesondere sind unterschiedliche Naßätzraten der Isolatorschichten im Schritt c wichtig für die Formung vorteilhafter Seitenwände der Kollektorfenster. Unter Ausnutzung der Ätzratenunterschiede unterschiedlicher Oxid-Arten bei nasschemischer Behandlung sowie der Eigenschaften anisotroper Trockenätzverfahren gelingt es weiterhin in Schritt g mit Hilfe der erfindungsgemäß eingesetzten Schichtkombination, im Vergleich mit dem Stand der Technik bei ähnlicher lithographischer Strukturbreite die Aufweitung von Emitter- bzw. Kollektorfenster zu verringern und damit kleinere laterale Abmessungen zu erzeugen. Gleichzeitig werden erfindungsgemäßen Modifikationen genutzt, um im Rahmen der Schritte c und g für die elektrischen Eigenschaften günstige Formen der Isolatorseitenwände am Kollektor- bzw. Emitterfenster zu gestalten.

Nachfolgend werden Ausführungsformen des erfindungsgemäßen Verfahrens beschrieben. Zur besseren Orientierung werden in der Beschreibung der Ausführungsformen, wo es sinnvoll erscheint, auch Bezugszeichen verwendet, die in der nachfolgenden Figurenbeschreibung näher eingeführt werden. Dies dient allein der Unterstützung des Verständnisses der jeweiligen Ausführungsformen und soll ihren Gegenstand nicht durch die spezifischen Merkmale der in der Figurenbeschreibung weiter unten erläuterten Ausführungsbeispiele begrenzen oder gar die Verwendung deren weiterer Merkmale in den jeweils beschriebenen Ausführungsformen implizieren.

In einer Ausführungsform des erfindungsgemäßen Verfahrens wird, nach der Formierung der Kollektorgebiete der HV- oder/und HS-Transistoren im Schritt b, zusätzlich eine Silizium-Pufferschicht auf den freigelegten Kollektorgebieten selektiv epitaktisch abgeschieden.

Die maskierten Implantationsschritte b1 und b2 können, wenn sie beide ausgeführt werden, in beliebiger Reihenfolge durchgeführt werden. Vorteilhafterweise wird vor Durchführung dieser maskierten Implantationsschritte eine Hilfsschicht (i) auf der Substratoberfläche abgeschieden, gefolgt von einem sukzessiven Öffnen der Hilfsschicht in zu implantierenden Transistorgebieten der Bipolartransistoren, während gegebenenfalls vorhandene Gebiete des Substrats mit MOS-Transistoren durch die Hilfsschicht (i) abgedeckt bleiben. Die Hilfsschicht (i) ist vorzugsweise als ein Schichtstapel verschiedener Materialien ausgebildet, der insbesondere mindestens eine Siliziumdioxid-Schicht und mindestens eine Siliziumnitrid-Schicht enthält.

Die lonenimplantationen der Kollektorgebiete der HS-HBTs und der HV-HBTs im Schritt b werden vorzugsweise jeweils so durchgeführt, dass eine näher zur Substratoberfläche befindliche Grenze einer Kollektor-Substrat-Raumladungszone weniger tief im Substrat ausgebildet ist als ein Boden der Feldisolationsgebiete.

In einer weiteren Ausführungsform wird das während der Kollektorimplantation im Schritt b gestörte Kristallgitter des Si-Substrats mittels einer Wärmebehandlung defektarm rekonstruiert wird.

In einer weiteren Ausführungsform des Verfahrens umfasst das Herstellen der Isolatorschichten (i1, i2, i3) im Schritt c für das Definieren von Kollektorfenstern als innere Transistorgebiete der HS- und HV-Transistoren vorteilhafterweise das Abscheiden zunächst einer ersten SiO₂-Schicht (i1) und danach einer zweiten, gegenüber Nassätzung in verdünnter Flusssäure im Vergleich mit der ersten SiO₂-Schicht (i1) ätzstabileren SiO₂-Schicht (i2). Vorzugsweise wird bei dieser Verfahrensführung das Verhältnis der Ätzraten der Schichten (i1) und (i2) größer als 1,5, weiter vorzugsweise größer als 2 eingestellt. Weiterhin wird die Schicht (i1) vorzugsweise mittels LPCVD (low pressure chemical vapor deposition)-TEOS und die Schicht (i2) vorzugsweise mittels plasmaverstärkter (PE) Oxidabscheidung erzeugt. Schließlich ist die Schicht (i2) vorzugsweise dicker als die Schicht (i1).

Die dritte Isolatorschicht i3 wird vorzugsweise als Siliziumnitrid-Hilfsschicht auf der zweiten SiO₂-Schicht (i2) abgeschieden.

In einer weiteren Ausführungsform umfasst das Definieren der Kollektorfenster der HS- und der HV-Transistoren im Schritt c ein Abtragen der Siliziumnitrid-Hilfsschicht (i3) sowie der zweiten SiO₂-Schicht (i2) in den mittels einer Lackmaske definierten Fenstern mit Hilfe eines oder mehrerer Trockenätzschritte, wobei eine Ätzzeit des Trockenätze-Schrittes so eingestellt wird, dass eine Ätzfront innerhalb der ersten SiO₂-Schicht (i1) hergestellt wird.

Das Definieren des Emitterfensters erfolgt bei der erfindungsgemäßen Verfahrensführung im Schritt e mit Hilfe eines Fensters in Isolatorschichten eines weiteren Isolator-Schichtstapels (i4, i5, i6) über der Cap-Schicht (C). Eine Ausführungsform umfasst zusätzlich das Durchführen einer Temperatur-Kurzzeit-Behandlung nach dem Abscheiden des Isolator-Schichtstapels (i4, i5, i6) über der Cap-Schicht (C).

Das Definieren des Emitterfensters im Schritt e umfasst dann vorzugsweise folgende Schritte:
- Strukturieren einer PECVD-Oxid-Schicht (i6) des Isolatorschichtstapels durch Trockenätzen, vorzugsweise unter Ätzbedingungen, die eine daran angrenzende Siliziumnitridschicht (i5) des Isolatorschichtstapels kaum oder gar nicht abtragen;
- Weiteres Öffnen der Siliziumnitridschicht (i5), beispielsweise durch ein isotropes Nassätzverfahren zur Unterstützung einer Aufweitung der Öffnung nach oben hin.

Eine nachfolgende selektive lonenimplantationen zur Formierung der HS-SIC-Dotierung und/oder der HV-SIC-Dotierung erfolgt dann vorteilhafterweise in selbstjustierter Weise zum Emitterfenster, wobei Gebiete außerhalb des Emitterfensters vom Isolatorschichtstapel (i4, i5, i6) vor der Implantation geschützt werden.

In einer weiteren Ausführungsform wird die Siliziumdioxidschicht (i7) im Schritt g mittels eines Niederdruck-CVD Prozesses mit Hilfe eines Trägergases abgeschieden, das BIS(tert-Butylamino)Silan enthält.

Im erfindungsgemäßen Verfahren erfolgt im Schritt j das Abscheiden einer Isolator-Schichtfolge (i8 bis i11) und das Strukturieren dieser Isolator-Schichtfolge (i8 bis i11), der Emitterschicht und der Isolatorschicht (i6) zur Bildung eines T-förmigen Emitters. In einer vorteilhaften Ausführungsform der Erfindung erfolgt die Strukturierung der Emitterschicht mit Hilfe der Isolator-Schichtfolge, die in dieser Ausführung als Schichtfolge von vier Einzelschichten aus Siliziumoxid, Siliziumnitrid, Siliziumoxid und Siliziumnitrid ausgeführt ist. Mit dieser alternierenden Folge von Siliziumoxid- und Siliziumnitridschichten anstelle einer einzelnen Oxidschicht oder eines Schichtstapels aus Siliziumdioxid und Siliziumnitrid gelingt es, auch bei variabler Höhe des Emitter-Poly-Siliziums die laterale und vertikale Dicke der Verkapselung des Emitters unabhängig voneinander den Erfordernissen anzupassen und zugleich eine schadensfreie Entfernung der Hilfsschichten sicherzustellen.

Eine weitere vorteilhafte Ausführungsform der Erfindung berührt die Einbringung von Dotierstoff in das externe Basisgebiet. Dem Stand der Technik folgend sind in-situ Dotierungen vom Leitungstyp der Basis während der epitaktischen Verstärkung des Basisanschlussgebietes, aber auch anschließend durch Ionenimplantation vorgesehen. Im Gegensatz zu früheren Auffassungen, die die Vermeidung von Implantationsschäden in der Nähe des inneren Basisgebietes betreffen, wird im hier beanspruchten erfindungsgemäßen Verfahren auch eine spezielle Implantation der externen Basisgebiete vor der epitaktischen Verstärkung eingeschlossen. Die Verfahrensführung dieses Ausführungsbeispiels umfasst nach Herstellung der seitlichen Spacer an den Seitenflächen des Emitters und nach der Entfernung der Siliziumnitrid-Schicht und vor der Höhenerweiterung der Basisanschlussschicht das Durchführen einer Schrägwinkelimplantation mit Waferdrehung, um außerhalb der inneren Transistorgebiete oberflächennahe Regionen der Basis und der Cap-Schicht mit einer hohen Konzentration an Störstellen vom Leitfähigkeitstyp der Basis zu versehen.

Einen von der beschriebenen Verfahrensführung unabhängigen zweiten Aspekt der vorliegenden Erfindung bildet wie erläutert eine BiCMOS-Halbleitervorrichtung gemäß Anspruch 14, umfassend Hochgeschwindigkeitsbipolartransistoren, nachfolgend HS-Transistoren, und Hochspannungs-Bipolartransistoren, nachfolgend HV-Transistoren. Die Vorrichtung umfasst:
a. ein Substrat mit aktiven Gebieten und grabenförmigen flachen Feldisolationsgebieten, die die aktiven Gebiete lateral umschließen;
b1. in den für die HV-Transistoren vorgesehenen aktiven Gebieten jeweils ein zusammenhängendes hochleitfähiges HV-Kollektorgebiet eines ersten Leitfähigkeitstyps; und
b2. in den für die HS-Transistoren vorgesehenen aktiven Gebieten jeweils ein zusammenhängendes hochleitfähiges HS-Kollektorgebiet des ersten Leitfähigkeitstyps;
c1. eine erste selektive Kollektordotierung, nachfolgend HV-SIC-Dotierung, die auch in den HS-Transistorgebieten vorliegen kann, und
c2. eine zusätzliche zweite selektive Kollektordotierung, nachfolgend HS-SIC-Dotierung, die ausschließlich in den HS-Transistoren im jeweiligen inneren Transistorgebiet vorliegt, wobei die Dotierungen der Kollektorgebiete so gewählt sind, dass die vertikale Erstreckung der Basis-Kollektor-Raumladungszone im HV-Transistor größer als im HS-Transistor ist;
d. innerhalb des jeweils selben, von demselben Feldisolationsgebiet umschlossenen aktiven Gebiet, in dem der jeweilige Basisschichtstapel angeordnet ist, ein Kollektoranschlussgebiet, welches das Kollektorgebiet der HS-Transistoren und der HV-Transistoren mit einem Kollektorkontakt verbindet;
e. in einem von Isolatorschichten umgrenzten Kollektorfenster der HV-Transistoren und der HS-Transistoren jeweils ein Basisschichtstapel, der eine epitaktische Pufferschicht, eine einkristalline, nicht-selektiv epitaktisch abgeschiedene Basisschicht eines zweiten, dem ersten entgegengesetzten Leitfähigkeitstyps und eine einkrisbtalline Cap-Schicht aufweist, wobei aufgrund der nicht-selektiven epitaktischen Abscheidung der Basisschicht auf den Isolatorsschichten im Bereich der Basisschicht und der Capschicht ein zumindest an diese Schichten polykristallin anschließender Schichtstapel eines Basisanschlussgebiets angeordnet ist;
f. eingebettet in Basis-Emitter-Spacer und eine weitere Isolatorschicht der HV-Transistoren und der HS-Transistoren jeweils eine hoch dotierte, einkristalline oder polykristalline T-förmige Emitterschicht des ersten Leitfähigkeitstyps und seitliche Spacer an nach außen weisenden Seitenflächen der Emitterschicht und der weiteren Isolatorschicht; und
g. außerhalb des Emitters der HV-Transistoren und der HS-Transistoren jeweils eine Höhenerweiterung der Basisanschlussschicht.

Die Vorrichtung des zweiten Aspekts teilt die Vorteile der Verfahrensführung des ersten Aspekts. Zum einen wird die aus dem Stand der Technik bekannte Anordnung des HV-Transistors mit einem zusätzlichen flachen, in STI-Technik gefertigten Feldisolationsgebiet, das zwischen dem innerem Transistorgebiet und dem Kollektorkontakt angeordnet ist, abgelöst durch eine Konstruktion, die im Querschnittsbild dem des High-Speed Transistors entspricht. Mit anderen Worten, in den für die HV-Transistoren vorgesehenen aktiven Gebieten gibt es jeweils nur ein zusammenhängendes hochleitfähiges HV-Kollektorgebiet eines ersten Leitfähigkeitstyps. Diese Ausbildung der erfindungsgemäßen Vorrichtung zeichnet sich durch besonders geringe Werte des Kollektorwiderstands, der Basis-Kollektor-Kapazität und der Kollektor-Substrat-Kapazität aus. Damit werden sowohl die Hochspannungsfestigkeit als auch Hochfrequenzeigenschaften verbessert.

Nachfolgend werden weitere Ausführungsbeispiele mit Bezug auf die Zeichnungen beschrieben.

### KURZBESCHREIBUNG DER ZEICHNUNGEN

Es zeigen:
Fig. 1 bis Fig. 20 ein erstes Ausführungsbeispiel eines Verfahrens zur Herstellung von Bipolartransistoren mit nichtselektiver Basisepitaxie und erhöhtem Basisanschlussgebiet;
Fig. 21 bis Fig. 25 ein zweites Ausführungsbeispiel eines Verfahrens zur Herstellung von Bipolartransistoren mit nichtselektiver Basisepitaxie und erhöhtem Basisanschlussgebiet.

### DETAILLIERTE BESCHREIBUNG VON AUSFÜHRUNGSBEISPIELEN

Die nachfolgend vorgestellten Verfahren am Beispiel der Herstellung von npn-Bipolartransistoren umfassen die Realisierung von Hochgeschwindigkeits- (HS, engl. High-Speed) und Hochspannungs- (HV, engl. High-Voltage) Transistoren. Es sei angemerkt, dass auf die Fertigung eines der beiden Typen verzichtet werden kann, ohne dass Effekte beim jeweiligen anderen Typ auftreten.

### Beispiel 1

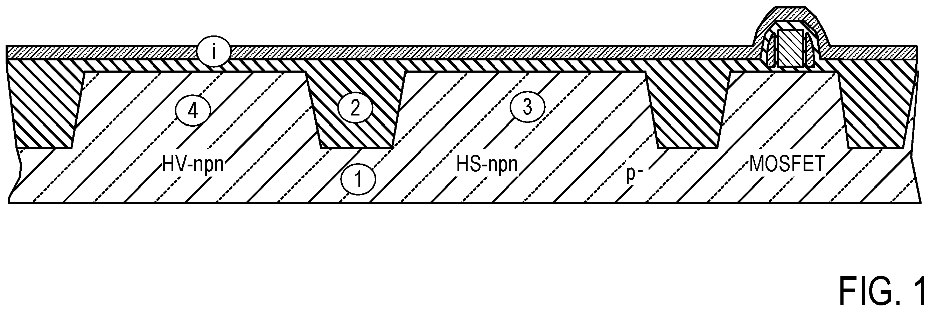

Ein erstes Verfahren zur Herstellung von Bipolartransistoren mit nichtselektiver Basisepitaxie und erhöhtem Basisanschlussgebiet wird in Bezug auf Fig. 1 bis Fig. 20 erläutert. In den nachfolgenden Figuren werden gleiche Strukturelemente durch gleiche Nummern bezeichnet.

Insbesondere ermöglicht das erfindungsgemäße Verfahren die Herstellung von Hochgeschwindigkeits- und Hochspannungs-Bipolartransistoren in integrierten Bipolar- und BiCMOS-Prozessen.

In dem Ausführungsbeispiel handelt es sich um ein Verfahren zur Herstellung von npn-Bipolartransistoren auf einem p-leitenden Substrat 1. Auf dem Substrat 1 sind aktive Gebiete und eine erste Art Isolationsgebiete 2 strukturiert. Diese Isolationsgebiete 2, im Weiteren als Feldisolationsgebiete bezeichnet, ragen von der Substratoberfläche aus ins Substratgebiet hinein. Als Feldisolationsgebiete können sogenannte "Shallow-Trench" Isolationen (STI) eingesetzt werden. Dabei handelt es sich um vorzugsweise 300 bis 600nm tiefe Gräben, die z.B. mit Siliziumdioxid (SiO2), aber auch mit einer Kombination aus Isolatormaterial und Polysilizium verfüllt sein können. Aber auch mittels lokaler Oxidation (LOCOS) hergestellte Feldisolationsgebiete können eingesetzt werden.

In den CMOS-Gebieten werden n- und p-leitende Wannen hergestellt und Gates aus PolySilizium strukturiert und mit seitlichen Spacern versehen.

Auf den wie beschrieben strukturierten Si-Scheiben wird eine Hilfsschicht i abgeschieden. Bei dieser Hilfsschicht kann es sich insbesondere um einen Schichtstapel verschiedener Materialien, insbesondere aus Siliziumdioxid und Siliziumnitrid, handeln (Fig. 1).

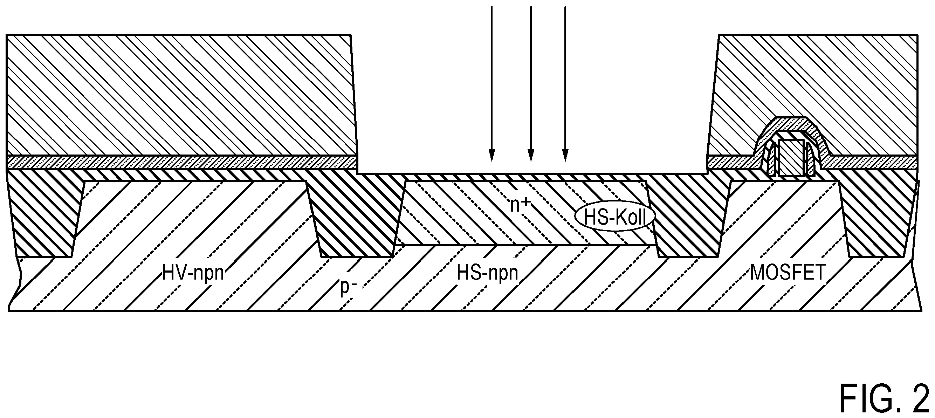

Die Hilfsschicht i wird mit Hilfe einer ersten Lackmaske über den aktiven Gebieten des HS-Bipolartransistors 3 geöffnet (Fig. 2). Die Strukturierung der Hilfsschicht i erfolgt durch reaktives Ionenätzen (Reactive Ion Etching, RIE), auch als Trockenätzen (Dry-Etching) bezeichnet. Noch vor dem Entfernen der Lackmaske wird durch eine maskierte Ionenimplantation das hoch n-leitende Kollektorgebiet des HS-Transistors (HS-Koll) erzeugt.

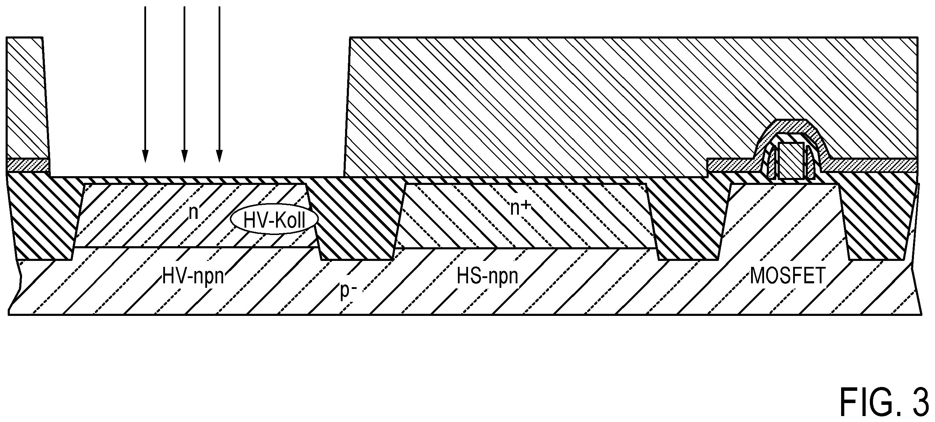

Mit Hilfe einer zweiten Lackmaske wird die Hilfsschicht i über dem Gebiet der HV-Bipolartransistoren 4 entfernt und dort ein auf die Forderungen an einen Hochvolt-Transistor zugeschnittenes Kollektorprofil (HV-Koll) per Ionenimplantation hergestellt (Fig. 3). Die Kollektorgebiete der HS- und HV-Transistoren werden seitlich von den Isolationsgebieten erster Art begrenzt. Vorzugsweise liegt der STI-Boden tiefer als die kollektorseitige Ausdehnung der Kollektor-Substrat-Raumladungszone, um die Kollektor-Substrat-Kapazität gering zu halten.

Nach Entfernung der Lackmaske und üblichen nasschemischen Reinigungsschritten werden mittels RTP die Kollektorimplante einer Wärmebehandlung ausgesetzt, um das während der Kollektorimplantation gestörte Kristallgitter des Si-Substrates defektarm zu rekonstruieren.

Wahlweise können die Kollektorgebiete der HS-HBTs 3 oder der HV-HBTs 4 auch vor der Abscheidung der Isolatorschicht i lokal implantiert werden. Insbesondere kann der HS-Kollektor vor der Abscheidung der Schicht i erzeugt werden und der HV-Kollektor gemeinsam mit der Öffnung der Schicht i und der dafür verwendeten Lackmaske eingebracht werden.

Vorzugsweise werden vor den nachfolgenden Isolatorbeschichtungen Restoxidschichten auf den Aktivgebieten der Bipolartransistoren entfernt.

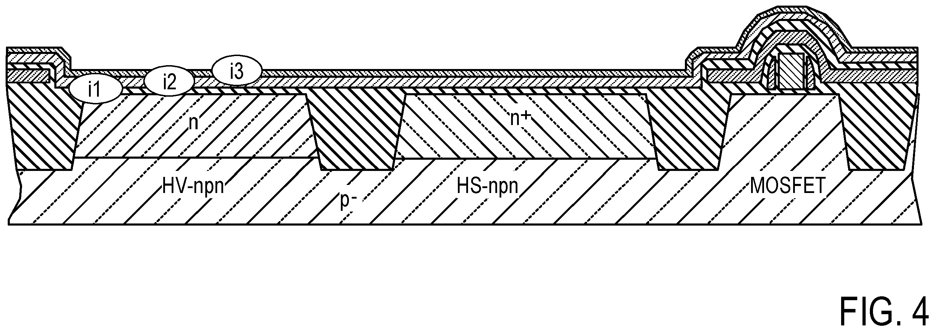

Im Anschluss werden auf der Substratoberfläche Isolationsgebiete 2. Art erzeugt. Im erfindungsgemäßen Fall startet die Herstellung mit der Abscheidung von zwei Oxidschichten i1 und i2 (Fig. 4). Es handelt sich bei Schicht i1 um eine 15nm bis 100nm dicke, vorzugsweise 25 bis 50nm dicke LPCVD-TEOS-Schicht oder um eine in Bezug auf nasschemisches Ätzverhalten äquivalente Abscheidung, wie z.B. eine Atomic-Layer-Beschichtung (ALD). Darüber wird eine 25nm bis 100nm, vorzugsweise 50nm bis 80nm dicke PECVD-SiO2-Schicht abgeschieden. Der wesentliche Grund für die Verwendung einer zweiten, oberhalb vom TEOS liegenden Oxidschicht resultiert aus der Möglichkeit, mit PECVD-Oxiden eine im Vergleich zu TEOS kleinere Ätzrate in verdünnter Flusssäure nutzen zu können. Die um den Faktor 1.5 bis 3 kleinere Ätzrate verringert zum einen die Aufweitung des Kollektorfensters beim Freilegen der Substratoberfläche. Zum anderen bewirkt die größere Ätzrate von TEOS einen Überhang des PECVD-Oxides. Dieser Überhang bietet günstigere Möglichkeiten, die von den Isolationsgebieten 2. Art umschlossenen inneren Transistorgebiete bei späterer selektiver Epitaxie möglichst horizontal gleichmäßig ohne Spalten und Versetzungen mit Si zu füllen. Weitere Kriterien für die Eignung eines speziellen PECVD-Oxides sind dessen Kantenbedeckungsfähigkeit, aber auch das Bekeimungsverhalten während selektiver Epitaxie.

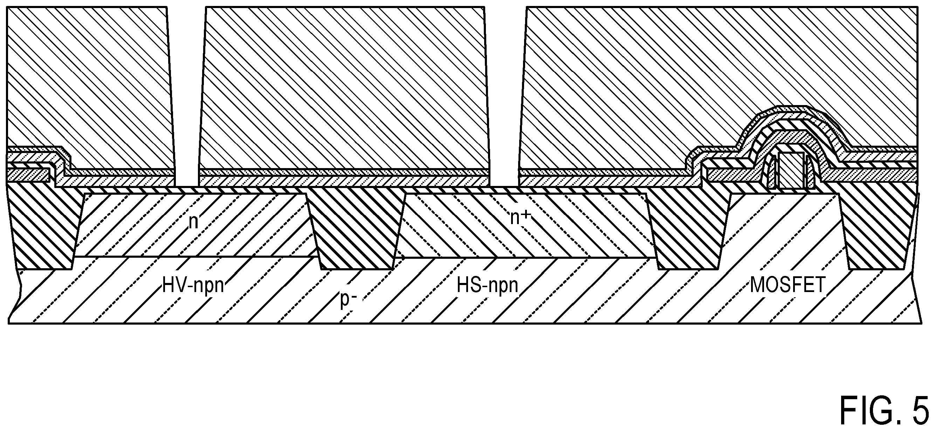

Über dem Doppel-Oxid-Stapel wird eine 10nm bis 100nm, vorzugsweise 20nm bis 50nm dicke Siliziumnitrid-(Si3N4)Schicht i3 abgeschieden. i3 dient als Hilfsschicht für die Herstellung der inneren Transistorgebiete. Mit Hilfe einer fotolithografisch strukturierten Lackmaske werden in den Kollektorfenstern der HS- als auch der HV-Transistoren die Si3N4-sowie die PECVD-Oxidschicht über Trockenätzverfahren abgetragen (Fig. 5) und die Ätzzeit des RIE-Schrittes so eingestellt, dass am Ende des Prozesses die Ätzfront innerhalb der TEOS-Schicht liegt. Dadurch wird eine wirksame Entkopplung von Restoxiddicke und Aufweitung des Kollektorfensters erreicht.

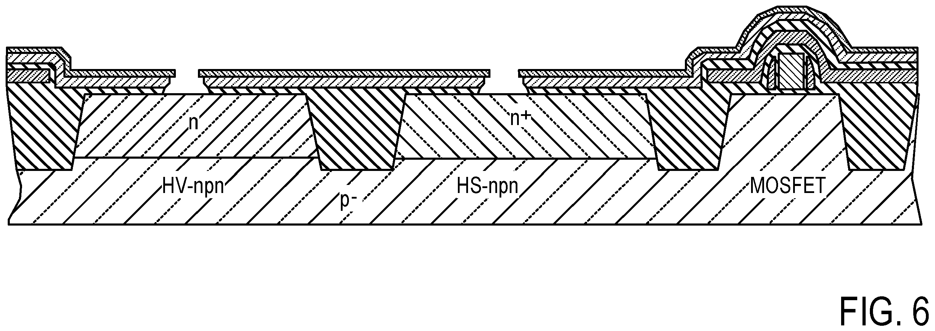

Nach Entfernung der Lackmaske wird mit Hilfe Siliziumdioxid ätzender, nasschemischer Verfahren SiO2 im Kollektorfenster selektiv zum Siliziumnitrid abgetragen und dort die Substratoberfläche freigelegt (Fig. 6). Anschließend wird die Siliziumnitridschicht i3 mit nasschemischen Mitteln selektiv zu Siliziumdioxid, z.B. in heißer Phosphorsäure, entfernt.

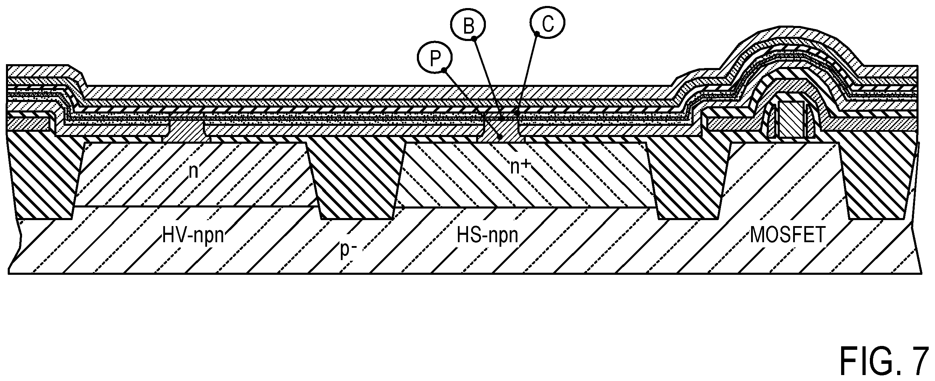

Auf den so geöffneten inneren Gebieten des Bipolartransistors wird mit selektiver Epitaxie auf den inneren Kollektorfenstern die Pufferschicht P aus Silizium gewachsen, bevor mit einem nichtselektiven Epitaxieschritt die einkristalline Basisschicht B und die einkristalline Si Cap-Schicht C erzeugt werden. Die Basisschicht B kann insbesondere eine SiGe-Schicht und eine Dotierung mit Kohlenstoff enthalten. Die p-Dotierung der intrinsischen Basis wird während des Schichtwachstums in-situ eingebracht. Auf den freigelegten Isolationsgebieten 2 wächst ein polykristalliner Si/SiGe/Si-Schichtstapel (Fig. 7).

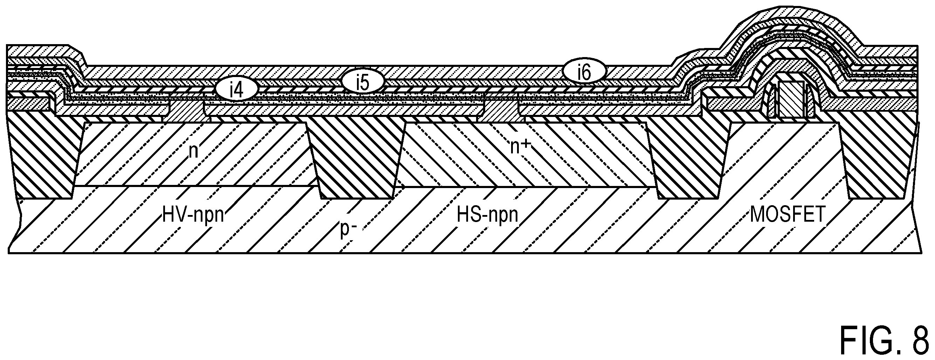

Über der Cap-Schicht C wird ein Schichtstapel, bestehend aus einer Siliziumdioxid- i4, einer Siliziumnitrid- i5 und einer PECVD-Oxid-Schicht i6, abgeschieden (Fig. 8). Die Hilfsschicht i4 besteht vorzugsweise aus einer LPCVD-TEOS Schicht, beispielsweise mit einer Dicke von 3nm bis 20 nm, i5 aus einer Siliziumnitridschicht, beispielsweise mit einer Dicke von 30nm bis 100nm. Die Dicke der PECVD-Oxidschicht i6 kann beispielsweise von 50nm bis 150nm betragen. Der Stapel i4, i5 und i6 wird einer Temperatur-Kurzzeit-Behandlung ausgesetzt. Dabei werden Temperaturen kleiner als 850°C, vorzugsweise kleiner als 750°C, und Zeiten kleiner als 5 Minuten angewendet. Die erfindungsgemäße Anwendung von PECVD-Siliziumdioxid als Deckelschicht i6 sowie deren Kurzzeit-Temperaturbehandlung zielen auf eine Reduktion der Aufweitung des Emitterfensters bei späteren nasschemischen Prozessen.

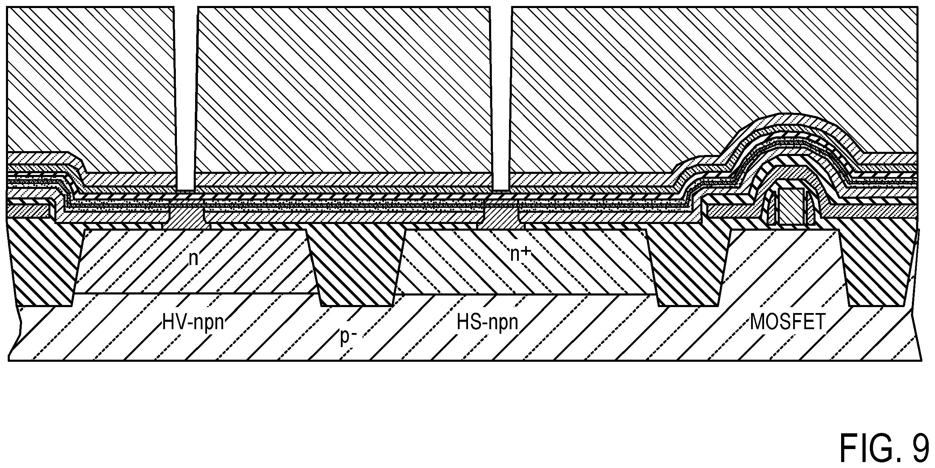

Mit Hilfe einer Lackmaske wird in den Isolatorschichten i5 und teilweise in i6 ein Fenster geöffnet, das die aktive Emitterfläche definiert (Fig. 9). Dieses Fenster wird auch als Emitterfenster bezeichnet. Die Strukturierung der Isolatorschicht i6 erfolgt durch RIE. Diese anisotrope Trockenätzung nutzt bis zum Erreichen der Siliziumnitridschicht i5 vorzugsweise Ätzbedingungen, die i5 kaum oder gar nicht abtragen. Anschließend wird die Lackmaske entfernt und die Hilfsschicht i5 weiter geöffnet, beispielsweise durch ein isotropes Nassätzverfahren. Das Nassätzverfahren ätzt selektiv die Schicht i5 aus Siliziumnitrid, nicht aber die Schichten i4 und i6, die aus Siliziumdioxid bestehen. Durch das isotrope Ätzen wird die in Fig. 9 gezeigte Aufweitung der Öffnung der Hilfsschicht i5 nach oben hin unterstützt.

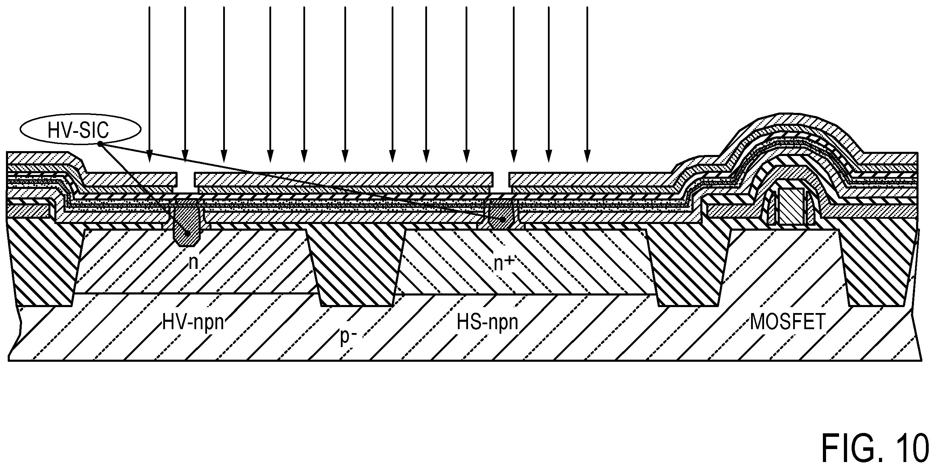

In einer Ausgestaltung der Erfindung wird an dieser Stelle eine für die Zwecke des HV-Transistors geeignete Ionenimplantation vom Typ des Kollektors eingebracht (Fig. 10). Diese Implantation bringt keine Nachteile für die gleichzeitig freiliegenden HS-Transistoren. Die zusätzliche Kollektordotierung HV-SIC ist selbstjustiert zum Emitterfenster, weil Gebiete außerhalb des Emitterfensters vom Stapel i4, i5 und i6 vor der Implantation geschützt werden.

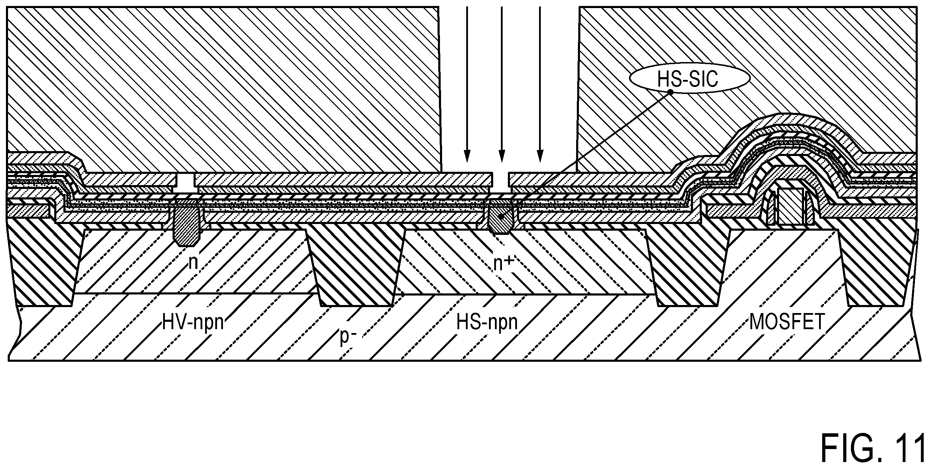

Dagegen schirmt eine nur über den HS-Emitterfenstern geöffnete Lackmaske die HV-Gebiete ab, wenn die HS-SIC-Dotierung zum Emitterfenster (HS-SIC), wiederum selbstjustierend, eingebracht wird (Fig. 11).

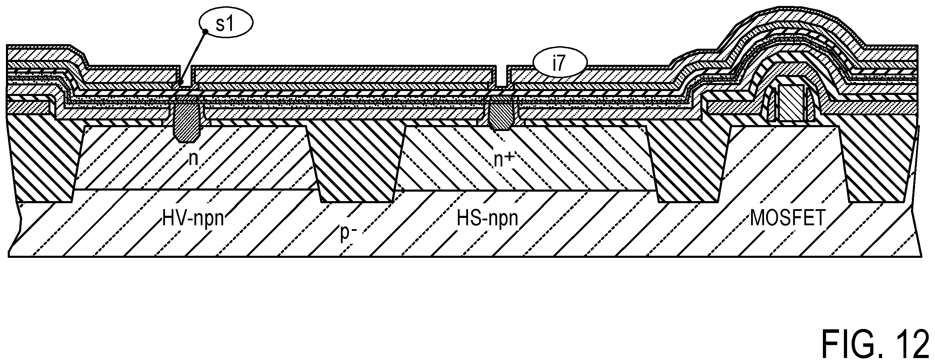

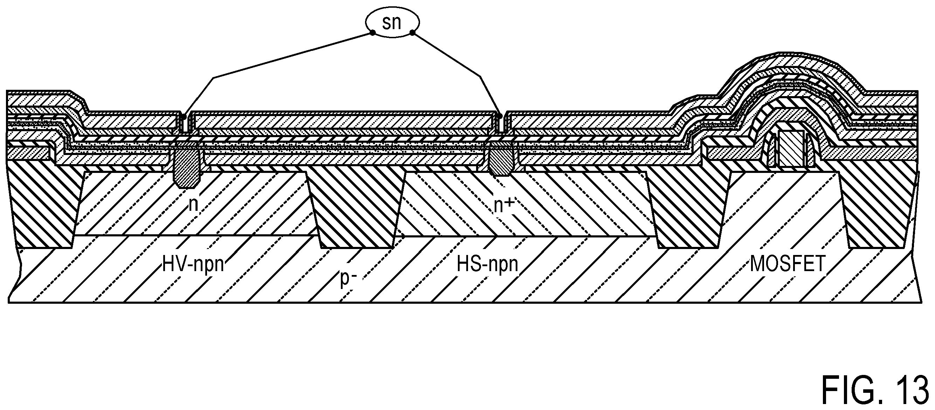

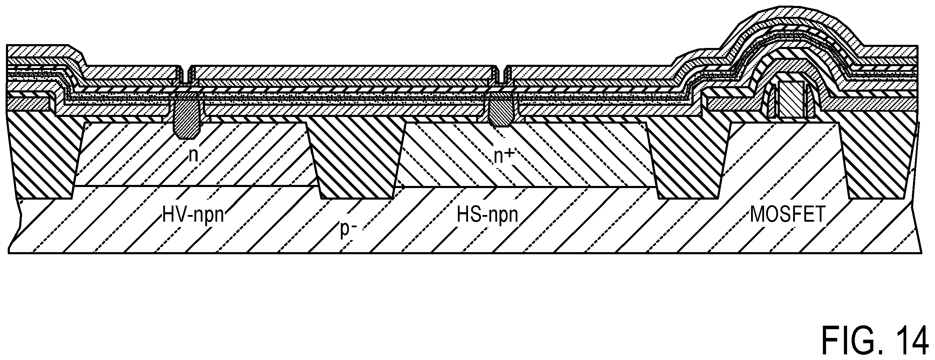

In einem weiteren Schritt wird eine Isolatorschicht i7 abgeschieden, die aus einer speziellen Siliziumdioxidschicht besteht und eine Dicke von 30nm bis 70nm hat (Fig. 12). Diese auf dem Trägergas BTBAS basierende LPCVD-Abscheidung besitzt den Vorteil, dass sich eine bis auf den Faktor 2 kleinere Ätzrate in verdünnter Flusssäure ergibt. Dieser für die erfindungsgemäße Ausgestaltung bedeutsame Vorteil wird auch nicht wesentlich dadurch geschmälert, dass eine Ausheilung im Temperaturbereich bis etwa 650°C unmittelbar nach dem BTBAS-Oxid-Prozess empfohlen wird. Die Isolatorschicht i7 wird teilweise mittels eines anisotropen RIE-Prozesses zurückgeätzt, wobei innerhalb des geöffneten Emitterfensters Spacer s1 geformt werden (Fig. 12). Die Breite dieser SiO2-Spacer wird einerseits von der Abscheidedicke der Schicht i7, zum anderen aber auch von der lateralen, nasschemischen Zurückätzung der Siliziumnitrid-Hilfsschicht i5 in heißer Phosphorsäure bestimmt. Die Formierung des Basis-Emitter-Spacers wird fortgesetzt mit der Abscheidung einer Si3N4-Schicht, die vorzugsweise eine Dicke von 15nm bis 50nm besitzen kann, und der anisotropen RIE-Ätzung dieser Schicht (Fig. 13). Das Ende des Ätzvorganges wird von einem sogenannten Endpunktmechanismus, der auf den Grad des Abtrags von Si3N4 reagiert, eingeleitet, wodurch die Reproduzierbarkeit der Ätztiefe gesichert wird. Der dabei entstehende Siliziumnitrid-Hilfs-Spacer sn schützt die innen liegende Seitenwand des Oxid-Spacers s1 vor einem Angriff der nachfolgenden nasschemischen SiO2-Ätzung, bei dem im Emitterfenster die Substratoberfläche freigelegt wird (Fig. 14). Anschließend wird der Si3N4-Spacer in heißer Phosphorsäure selektiv zu SiO2 entfernt.

Mit Hilfe der erfindungsgemäßen Prozessänderungen bestehend aus der Verwendung von PECVD-Oxid als Isolatorschicht i6 mit zusätzlicher RTP-Behandlung, dem Einsatz eines ätzstabileren Spacermaterials auf BTBAS-Oxid-Basis, der Anwendung einer anisotropen RIE-Zwischenätzung in Kombination mit der Formierung eines Si3N4-Hilfsspacers gelingt es im Vergleich zum Stand der Technik, schmalere Emitterbreiten zusammen mit angepasst kleineren Basis-Emitter-Spacern herzustellen. Des Weiteren entsteht in Oberflächennähe ein steileres Profil der Seiteninnenwand des Emitter-Basis-Spacers gebildet aus den Isolatorschichten i4 und i7, welches die übliche, zum Emitterfenster hin seitlich flach auslaufende Form bei nasschemischer Aufätzung einer homogenen Oxidschicht ersetzt.

In einem weiteren Schritt wird der Emitter E epitaktisch abgeschieden. Der Emitter besteht vorzugsweise aus Silizium, das in-situ mit einer n+-Dotierung, vorzugsweise Arsen, versehen wird. Im Bereich des Emitterfensters kann der Emitter einkristallin oder polykristallin sein. Gewöhnlich wird vor dem Epitaxieschritt eine Nassreinigung in verdünnter Flusssäure angewendet, um im Emitterfenster dünne Oxidschichten über der Siliziumoberfläche zu entfernen und um freie Bindungen an der Si Oberfläche mit Wasserstoff abzusättigen. Es ist nicht unüblich, dass im Epi-Reaktor vor der Abscheidephase eine Temperaturbehandlung zwischen 800°C und 900°C ausgeführt wird, um restlichen Sauerstoff zwischen Cap- und Emitterschicht im Emitterfenster zu beseitigen. Auf diese Temperaturbelastung wird in einer Ausgestaltung der Erfindung verzichtet. In Kombination mit einer flächenhaften Arsenanreicherung an der Oberfläche der Cap-Schicht C zu Beginn der Si-Epitaxie können auf diese Weise geringe Eindringtiefen der As-Emitter-Dotierung und damit kleinere Emitter-Basis-Randkapazitäten sowie kleine Emitterwiderstände erzielt werden.

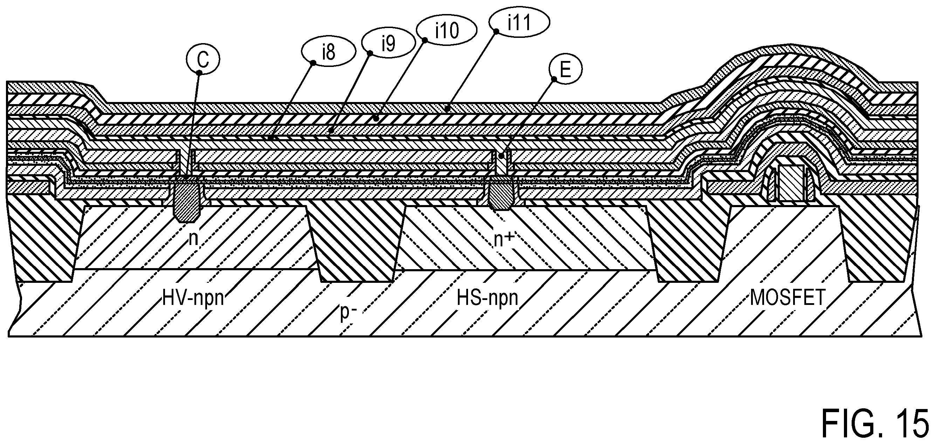

Oberhalb der Emitterschicht wird erfindungsgemäß ein Vierfachstapel i8, i9, i10 und i11, der abwechselnd aus Siliziumdioxid und Siliziumnitrid besteht, abgeschieden (Fig. 15). Die Siliziumdioxidschicht i8 hat vorzugsweise eine Dicke von 5nm bis 25nm, die darüber liegende Siliziumnitridschicht i9 kann bevorzugt 30nm bis 70nm dick sein, die Dicken von i10 und i11 liegen zwischen 20nm und 80nm.

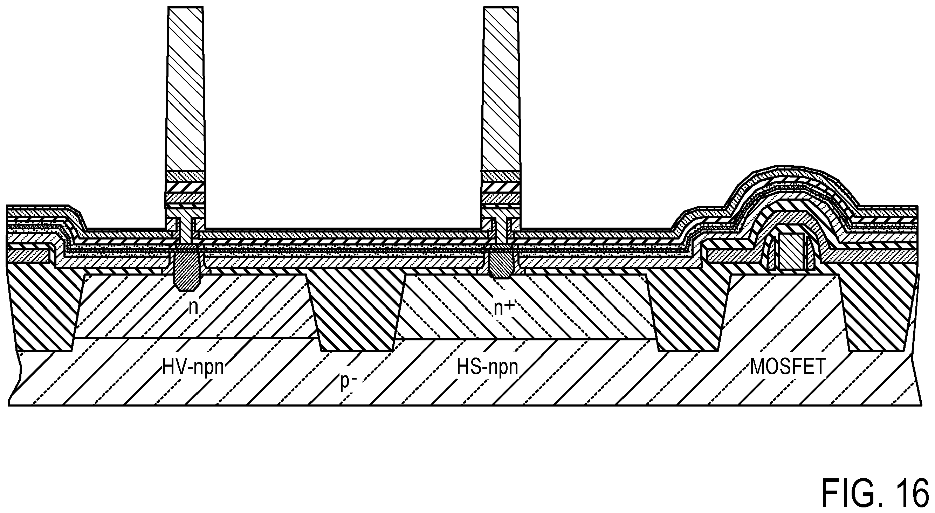

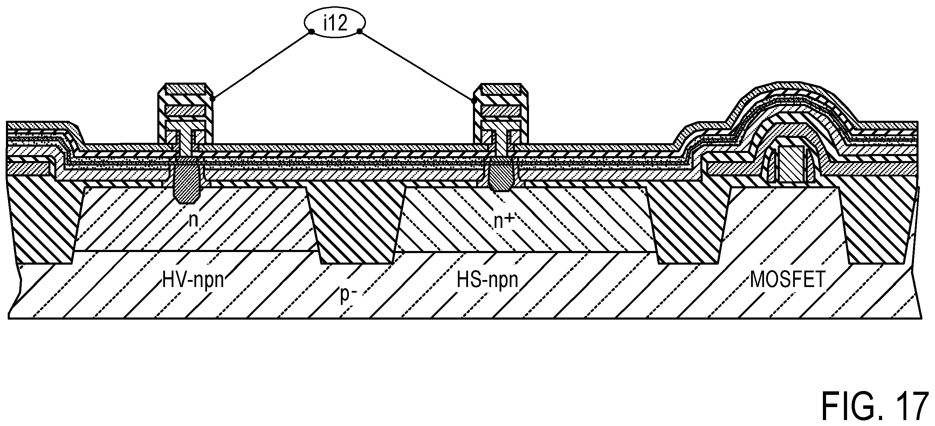

Die Emitterschicht E, die Isolatorschichten i8, i9, i10 und i11 sowie in dem bevorzugten Ablauf teilweise auch i6 werden in einem weiteren Schritt über eine Lackmaske strukturiert (Fig. 16). Anschließend werden an den seitlich nach außen weisenden Seitenflächen des Emitters Spacer i12 hergestellt, die beispielsweise aus Siliziumdioxid bestehen. Bei der anschließenden Spacerätzung kann die Hilfsschicht i5 als Stoppschicht genutzt werden (Fig. 17).

Anschließend werden die Si3N4-Hilfsschichten i5 und i11 beispielsweise in heißer Phosphorsäure abgetragen. Dieser selektive Nassätzprozess entfernt i5 und i11, aber nicht die aus Siliziumdioxid gebildete Umhüllung s1, i6, i12 und i11 des Emitters und auch nicht die Reste der aus SiO2 bestehenden Schicht i4.

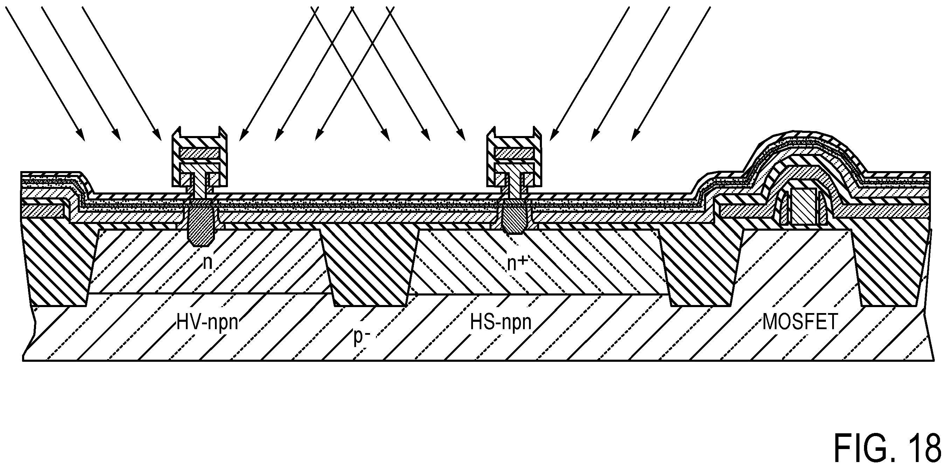

In einer Ausgestaltung der Erfindung wird in diesem Zustand eine Schrägwinkelimplantation mit Waferdrehung genutzt, um außerhalb der inneren Transistorgebiete die oberflächennahe Regionen der SiGe-Basis und Si-Cap-Schicht mit einer hohen Konzentration an Störstellen vom Leitfähigkeitstyp der Basis zu versehen. Vorzugsweise wird eine elektrisch neutrale Ionensorte zur Amorphisierung der oberflächennahen Si-Schicht eingesetzt, um bei nachfolgenden Implantationen Channeling zu vermeiden (Fig. 18). Eine Implantation an dieser Stelle im Prozessablauf gilt wegen der Gefahr verstärkter Diffusion oder Defektbildung der in Reichweite liegenden Basisdotierung als riskant und wurde bei Vorhandensein einer epitaktischen Verstärkung der externen Basisgebiete gemieden. Untersuchungen zeigten jedoch, dass es mit Hilfe der genannten Implantationsbedingungen gelingt, den Basiswiderstand weiter zu reduzieren und gleichzeitig spürbare Vorteile im Hochgeschwindigkeitsverhalten zu erreichen.

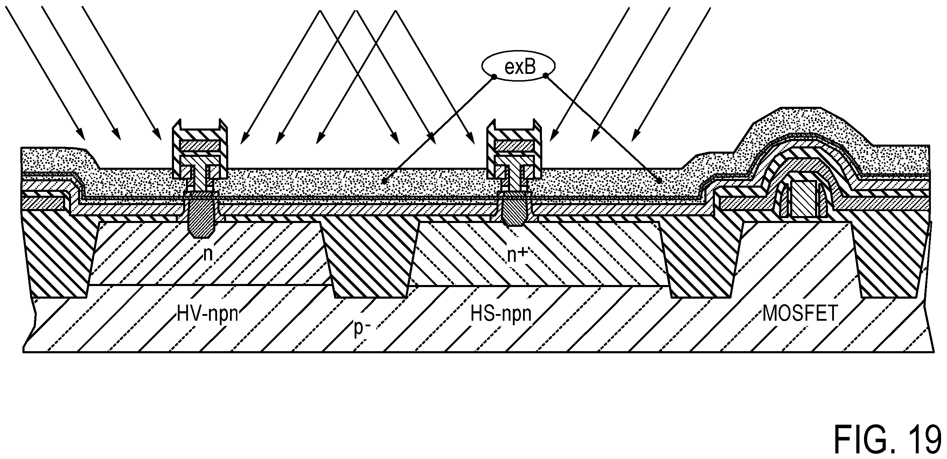

Die Oberfläche der Cap-Schicht C wird in den Bereichen außerhalb des Emitters, d.h. auf den externen Basisanschlussgebieten, durch Nassätzen freigelegt. Auf der freigelegten Oberfläche der Cap-Schicht C wird mittels selektiver Epitaxie die erhöhte Basisanschlussschicht exB gewachsen (Fig. 19). Die p-Dotierung der vorzugsweise in-situ während des Epitaxieschrittes vordotierten Basisanschlussschicht wird bevorzugt weiter durch Ionenimplantation erhöht. Die Energie und der Einfallswinkel der implantierten Ionen wird dabei so gewählt, dass ihre Eindringtiefe im durch die Isolationsgebiete 2. Art seitlich umschlossenen Transistorgebiet auf den Bereich oberhalb des Maximums der Dotierung der epitaxialen Basisschicht B beschränkt ist, um eine Erhöhung der Basis-Kollektor-Kapazität zu vermeiden. Darüber hinaus werden die über den Isolationsgebieten 2. Art liegenden, erhöhten Basisanschlussgebiete weitgehend komplett mit hoher Dotierstoffkonzentration ausgestattet. Hierfür wird eine senkrechte oder nahezu senkrechte Implantationsrichtung angewendet, wobei das innere Transistorgebiet einschließlich der Emitter von der Einhüllung der Emitterschicht geschützt werden.

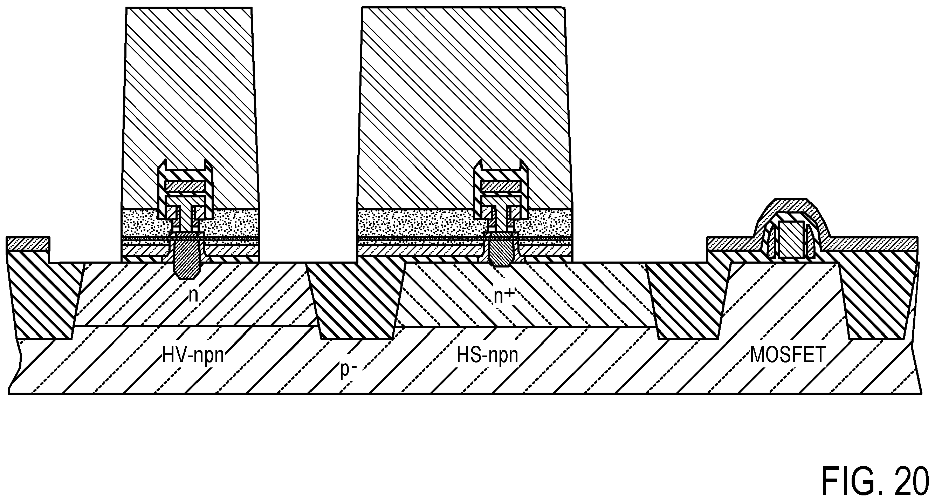

In einem weiteren Schritt werden die Epitaxieschichten P, B, C und exB mit Hilfe einer weiteren Lackmaske von den Kollektoranschlussgebieten und von den CMOS-Gebieten vollständig entfernt. Dafür kann ein RIE-Prozess genutzt werden, der auf der Hilfsschicht i2 stoppt. Anschließend werden die Hilfsschichten i1 und i2 entfernt (Fig. 20). Die CMOS-Gebiete befinden sich damit wieder in dem gleichen Zustand wie vor der Abscheidung der Hilfsschicht i1 und i2.

In einem BiCMOS-Prozess erfolgt in den folgenden Prozessschritten die Dotierung der Source-Drain-Gebiete der MOS-Transistoren entsprechend dem bekannten Stand der Technik.

### Beispiel 2

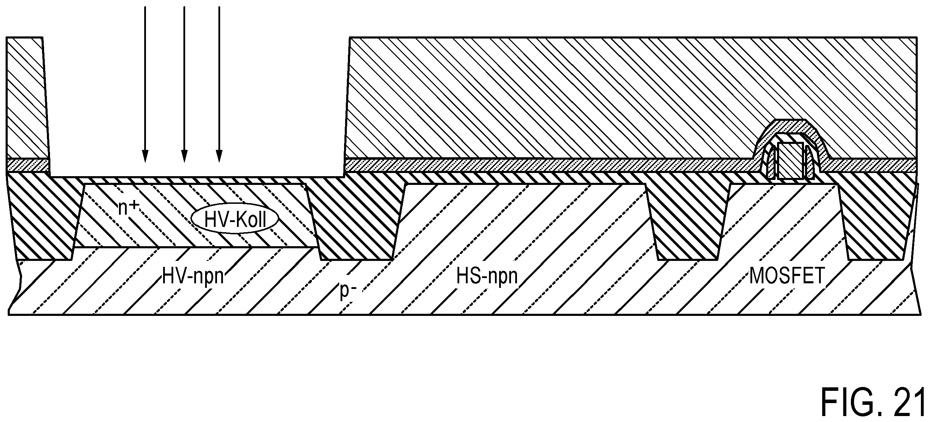

Ein zweites Verfahren zur Herstellung von Bipolartransistoren mit nichtselektiver Basisepitaxie und erhöhten Basisanschlussgebieten wird nachfolgend anhand der Fig. 21 bis 25 erläutert. Es unterscheidet sich von dem in Beispiel 1 beschriebenen Verfahren im Wesentlichen durch die Herstellung der selektiv implantierten Kollektorgebiete der High-Speed (HS-SIC) und High-Voltage (HV-SIC) Transistoren. Die nachfolgende Beschreibung konzentriert sich auf Unterschiede der Verfahrensführung.

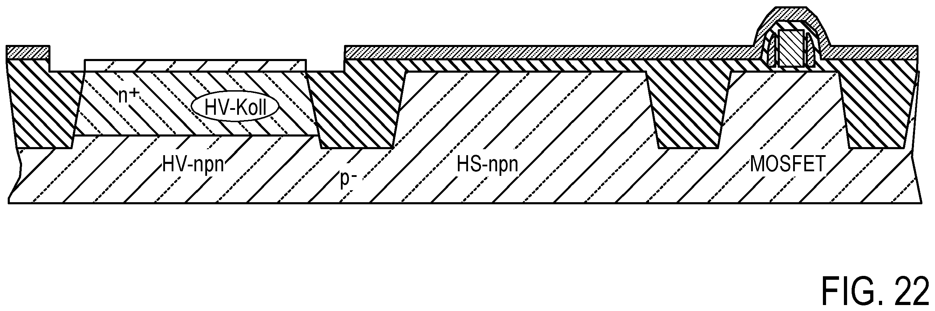

Bis zur Abscheidung der Hilfsschicht i ist das Verfahren identisch zu dem in Beispiel 1 beschriebenen Verfahren. Anschließend wird die Hilfsschicht i mit Hilfe einer ersten Lackmaske über den aktiven Gebieten des HV-Bipolartransistors geöffnet. Die Hilfsschicht i wird durch reaktives Ionenätzen strukturiert und noch vor dem Entfernen der Lackmaske wird durch eine maskierte Ionenimplantation das n-leitende Kollektorgebiet des HV-Transistors (HV-Koll) erzeugt (Fig. 21). In einer Ausgestaltung der Erfindung wird nach der Entfernung der Lackmaske in den freigelegten Kollektorgebieten der HV-Transistoren mittels selektiver Epitaxie eine undotierte oder schwach n-dotierte Si-Schicht einer Dicke von beispielsweise 10 nm bis 80 nm, vorzugsweise 10 nm bis 40 nm, abgeschieden (Fig. 22). Diese Schicht dient der Vergrößerung der Weite der Basis-Kollektor Raumladungszone und damit der Erhöhung der Durchbruchspannung des HV-Transistors.

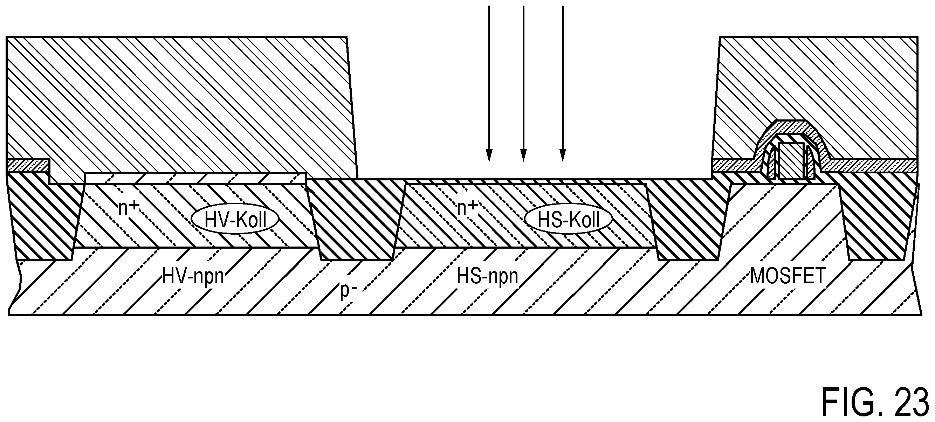

Mit Hilfe einer zweiten Lackmaske werden die Hilfsschicht i über dem Gebiet der HS-Bipolartransistoren entfernt und per Ionenimplantation dort die Kollektorgebiete (HS-Koll) für die Hochgeschwindigkeits-Transistoren hergestellt (Fig. 23). Nach Entfernung der Lackmaske und üblichen nasschemischen Reinigungsschritten werden mittels RTP die Kollektorimplante einer Wärmebehandlung ausgesetzt, um das während der Kollektorimplantation gestörte Kristallgitter des Si-Substrates defektarm zu rekonstruieren.

In einer Ausgestaltung der Erfindung werden die oben beschriebenen Kollektorgebiete (HS-Koll) sowohl für die Fertigung der Hochgeschwindigkeits-Transistoren (HS) als auch für Transistoren mit erhöhten Durchbruchsspannungen (HV) verwendet. Die weitere Differenzierung der beiden Transistortypen erfolgt in dieser Ausgestaltung durch die Realisierung von an die Anforderungen des jeweiligen Transistortyps angepassten, selektiv implantierten Kollektorregionen HS-SIC und HV-SIC mit den im folgenden beschrieben Verfahren.

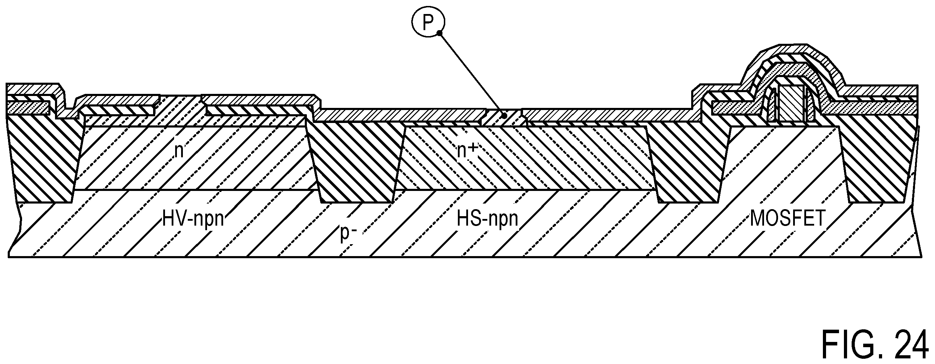

Im Anschluss an die Herstellung der Kollektorgebiete HV-Koll und HS-Koll werden wie in Beispiel 1 auf der Substratoberfläche Isolationsgebiete 2. Art erzeugt. Nach dem Öffnen der inneren Gebiete der Bipolartransistoren (Fig. 24) wird mit selektiver Epitaxie auf den inneren Kollektorfenstern die Pufferschicht P aus Silizium gewachsen. Im Unterschied zu Beispiel 1 werden nach der Abscheidung dieser Pufferschicht P zusätzliche Dotierungen der Kollektorgebiete durch Ionenimplantation erzeugt, die den unterschiedlichen Anforderungen der HS- und HV-Transistoren entsprechen.

In einer Ausgestaltung der Erfindung kann an dieser Stelle eine für die Zwecke des HV-Transistors geeignete Ionenimplantation vom Typ des Kollektors ohne weitere Maskierung eingebracht werden. Diese Implantation bringt keine Nachteile für die gleichzeitig freiliegenden HS-Transistoren. Außerdem ist die Implantationsenergie so gewählt, dass der über den CMOS-Gebieten liegende Schichtstapel aus der Hilfsschicht i und den Isolatorschichten i1 und i2 von den Ionen nicht durchdrungen wird.

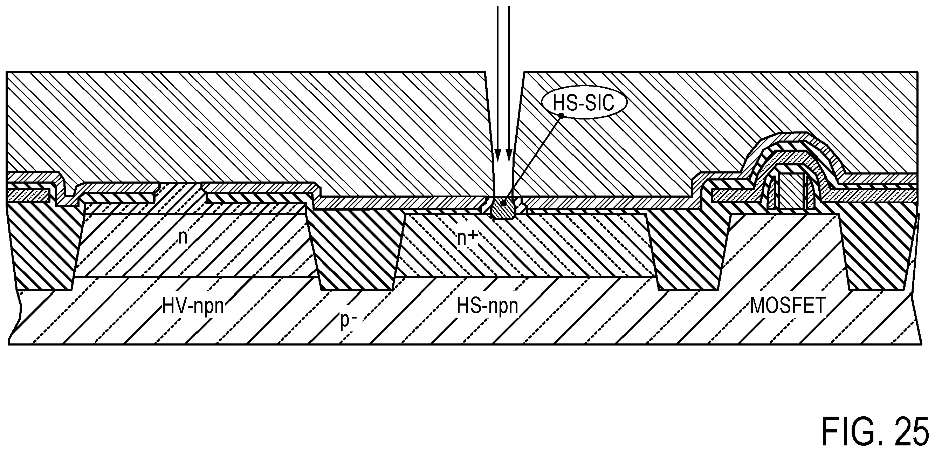

Selektiv implantierte Kollektorgebiete der Hochgeschwindigkeits-Transistoren (HS-SIC) werden mithilfe einer Lackmaske implantiert (Fig. 25). Die seitlichen Grenzen der implantierten HS-SIC-Gebiete werden durch die Kanten der Lackmaske definiert, die mit hoher Genauigkeit zu den Isolationsgebieten 2. Art justiert wird. Dadurch besteht die Möglichkeit, die laterale Ausdehnung der HS-SIC-Gebiete unabhängig von den anderen kritischen Transistordimensionen für beste Hochfrequenzeigenschaften der HS-Transistoren zu optimieren. Nach Entfernung der Lackmaske und üblichen nasschemischen Reinigungsschritten erfolgt eine Wärmebehandlung mittels RTP, um das während der Implantation gestörte Kristallgitter defektarm zu rekonstruieren.

Im Anschluss werden mit einem nichtselektiven Epitaxieschritt die einkristalline Basisschicht B und die einkristalline Si Cap-Schicht C erzeugt. Die Basisschicht B kann insbesondere eine SiGe-Schicht und eine Dotierung mit Kohlenstoff enthalten. Die p-Dotierung der intrinsischen Basis wird während des Schichtwachstums in-situ eingebracht. Auf den freigelegten Isolationsgebieten 2 wächst wie in Beispiel 1 ein polykristalliner Si/SiGe/Si-Schichtstapel.

Danach werden wie in Beispiel 1 ein aus den Schichten i4, i5 und i6 bestehender Schichtstapel abgeschieden und Emitterfenster geöffnet (Fig. 8, 9). In einer Ausgestaltung der Erfindung wird an dieser Stelle eine für die Zwecke des HV-Transistors geeignete Ionenimplantation vom Typ des Kollektors eingebracht (Fig. 10). Diese Implantation bringt keine Nachteile für die gleichzeitig freiliegenden HS-Transistoren.

Im Anschluss wird eine Isolatorschicht i7 abgeschieden (Fig. 12) und der Fertigungsprozess wie in Beispiel 1 fortgeführt.

Die Anwendung der erfindungsgemäßen Konstruktionsdetails oder Verfahrensschritte ist nicht auf die in den Beschreibungsbeispielen herangezogene Technologievariante beschränkt. Sie ist dort naheliegend, wo bei analogen Problemstellungen die hier beanspruchten Lösungen zu den angezielten Verbesserungen führen.

## Patentansprüche

1. Verfahren zur Herstellung, im Rahmen der Durchführung eines BiCMOS-Herstellungsprozesses, von Hochgeschwindigkeitsbipolartransistoren, nachfolgend HS-Transistoren, Fall A, oder von HS-Transistoren und Hochspannungs-Bipolartransistoren, nachfolgend HV-Transistoren, Fall AB, umfassend:
a. Bereitstellen eines Substrats mit aktiven Gebieten und grabenförmigen flachen Feldisolationsgebieten, die die aktiven Gebiete umschließen;
b. anschließend:
b1. im Fall AB: Durchführen einer maskierten ersten Ionenimplantation zur Bildung eines hochleitfähigen HV-Kollektorgebiets eines ersten Leitfähigkeitstyps in den für die HV-Transistoren vorgesehenen aktiven Gebieten; und
b2. Durchführen einer maskierten zweiten Ionenimplantation zur Bildung eines hochleitfähigen HS-Kollektorgebiets des ersten Leitfähigkeitstyps in den für die HS-Transistoren vorgesehenen aktiven Gebieten;
c. nachfolgend: Abscheiden von Isolatorschichten (i1, i2, i3) auf der Substratoberfläche und Definieren von Kollektorfenstern als innere Transistorgebiete der HS- und HV-Transistoren;
d. nachfolgend: selektives epitaktisches Abscheiden einer Pufferschicht (P) in den so definierten Kollektorfenstern, sowie auf der Pufferschicht nachfolgend nicht-selektives epitaktisches Abscheiden einer einkristallinen Basisschicht (B) eines zweiten, dem ersten entgegengesetzten Leitfähigkeitstyps und einer einkristallinen Cap-Schicht (C) auf der einkristallinen Basisschicht (B), wobei während des nicht-selektiven epitaktischen Abscheidens zugleich auf den Isolatorschichten (i1, i2) ein polykristalliner Schichtstapel wächst, und wobei das Abscheiden der Pufferschicht (P), der Basisschicht (B) und der Cap-Schicht (C) in einem gemeinsamen oder in zwei separaten Epitaxieschritten erfolgt;
e. nachfolgend: Abscheiden eines drei Isolatorschichten umfassenden Isolator-Schichtstapels (i4, i5, i6) über der Cap-Schicht (C) und anschließendes Definieren eines Emitterfensters durch Öffnen eines Fensters in den Isolatorschichten des Isolator-Schichtstapels;
f. Durchführung von Ionenimplantationen vom Dotierungstyp des Kollektors zur Formierung, im Fall A und AB, selektiv implantierter Kollektorgebiete der HS-Transistoren, nachfolgend HS-SIC-Dotierung, und, im Fall AB, selektiv implantierter Kollektorgebiete der HV-Transistoren, nachfolgend HV-SIC-Dotierung, wahlweise nach der Abscheidung der Pufferschicht (P) bei Ausführung der Abscheidungen in Schritt d in zwei separaten Epitaxieschritten oder nach Öffnung der Emitterfenster in Schritt e, umfassend
f1. Selektive Ionenimplantation in innere Kollektorgebiete der HS-Transistoren wobei die gegebenenfalls vorgesehenen HV-Transistoren durch eine Lackmaske oder durch den Isolatorstapel (i4, i5, i6) vor der Implantation geschützt werden,
f2. im Fall AB: Selektive Ionenimplantation in innere Kollektorgebiete der HV-Transistoren wobei die HS-Transistoren wahlweise durch eine Lackmaske abgedeckt sind oder ebenfalls diese Implantation der inneren Kollektorgebiete erfahren,
f3. im Fall AB: Wahl der Implantationsbedingungen der HS-SIC-Dotierung und der HV-SIC-Dotierung derart, dass eine vertikale Erstreckung einer Basis-Kollektor-Raumladungszone im HV-Transistor größer als im HS-Transistor ist;
g. nachfolgend: Abscheiden einer Siliziumdioxidschicht (i7) und Bilden von Basis-Emitter-Spacern (s1) innerhalb des Emitterfensters durch teilweises anisotropes Rückätzen der Siliziumdioxidschicht (i7) mit Hilfe eines Trockenätzverfahrens sowie Bildung von Hilfsspacern (sn) im Emitterfenster durch Abscheiden einer Siliziumnitridschicht und anschließendes anisotropes Rückätzen mit Stopp auf dem verbliebenen Teil der Siliziumdioxidschicht (i7);
h. nachfolgend: Freilegen einer durch die Capschicht gebildeten Oberfläche im Emitterfenster und nachfolgendes Entfernen der Hilfsspacer (sn);
i. nachfolgend: epitaktisches Abscheiden einer hoch dotierten, einkristallinen oder polykristallinen Emitterschicht (E) des ersten Leitfähigkeitstyps;
j. nachfolgend: Abscheiden einer Isolator-Schichtfolge (i8 bis i11) und Strukturieren der Isolator-Schichtfolge (i8 bis i11), der Emitterschicht und der Isolatorschicht (i6) zur Bildung eines T-förmigen Emitters, sowie Herstellen seitlicher Spacer (i12) an den nach außen weisenden Seitenflächen der Emitterschicht (E) und der Isolatorschicht (i6);
k. nachfolgend: Freilegen der Cap-Schicht (C) in Bereichen außerhalb des Emitters und selektive Epitaxie einer Höhenerweiterung einer Basisanschlussschicht (exB) mit in-situ Dotierung vom Leitungstyp der Basis (B); anschließend Erhöhen der Leitfähigkeit der Basisanschlussschicht durch eine Ionenimplantation; und
l. nachfolgend: Entfernen auf den Basisanschlussgebieten abgeschiedener Teile der Puffer-, Basis-, Cap- und der erhöhten Basisanschlussschicht von Kollektoranschlussgebieten.

2. Verfahren nach Anspruch 1, bei dem nach der Formierung der Kollektorgebiete der HV- oder/und HS-Transistoren im Schritt b zusätzlich eine Silizium-Pufferschicht auf den freigelegten Kollektorgebieten selektiv epitaktisch abgeschieden wird.

3. Verfahren nach Anspruch 1, bei dem die lonenimplantationen der Kollektorgebiete der HS-HBTs und der HV-HBTs so durchgeführt werden, dass eine Grenze einer Kollektor-Substrat-Raumladungszone auf deren näher zur Substratoberfläche liegenden Seite weniger tief im Substrat ausgebildet ist als ein Boden der Feldisolationsgebiete.

4. Verfahren nach einem der vorstehenden Ansprüche, bei dem das während der Kollektorimplantation gestörte Kristallgitter des Si-Substrates mittels einer Wärmebehandlung defektarm rekonstruiert wird.

5. Verfahren nach einem der vorstehenden Ansprüche, bei dem das Herstellen der Isolationsgebiete das Abscheiden zunächst einer ersten SiO₂-Schicht (i1) und danach einer zweiten gegenüber Nassätzung in verdünnter Flusssäure ätzstabileren SiO₂-Schicht (i2) umfasst, wobei
a) das Verhältnis der Ätzraten der Schichten (i1) und (i2) größer als 1.5, vorzugsweise größer als 2 ist;
b) die Schicht (i1) vorzugsweise mittels Niederdruck-CVD-TEOS und die Schicht (i2) vorzugsweise mittels plasmaverstärkter Oxidabscheidung erzeugt werden;
c) die Schicht (i2) vorzugsweise dicker als die Schicht (i1) ist.

6. Verfahren nach Anspruch 5, weiter umfassend
- Abscheiden einer Siliziumnitrid-Hilfsschicht (i3) auf der zweiten SiO₂-Schicht (i2) für die Herstellung der inneren Transistorgebiete.

7. Verfahren nach Anspruch 6, bei dem das Definieren der Kollektorfenster der HS- und der HV-Transistoren umfasst:
- Abtragen der Siliziumnitrid-Hilfsschicht (i3) sowie der zweiten SiO₂-Schicht (i2) in den mittels einer Lackmaske definierten Fenstern mit Hilfe eines oder mehrerer Trockenätzschritte, wobei eine Ätzzeit des Trockenätze-Schrittes so eingestellt wird, dass eine Ätzfront innerhalb der ersten SiO2-Schicht (i1) hergestellt wird.

8. Verfahren nach einem der vorstehenden Ansprüche, umfassend:
- Durchführen einer Temperatur-Kurzzeit-Behandlung nach dem Abscheiden des Isolator-Schichtstapels (i4, i5, i6) über der Cap-Schicht (C).

9. Verfahren nach einem der vorstehenden Ansprüche, bei dem das Definieren des Emitterfensters umfasst:
- Strukturieren einer PECVD-Oxid-Schicht (i6) des Isolatorschichtstapels durch Trockenätzen, vorzugsweise unter Ätzbedingungen, die eine daran angrenzende Siliziumnitridschicht (i5) des Isolatorschichtstapels kaum oder gar nicht abtragen;
- Weiteres Öffnen der Siliziumnitridschicht (i5), beispielsweise durch ein isotropes Nassätzverfahren zur Unterstützung einer Aufweitung der Öffnung nach oben hin.

10. Verfahren nach Anspruch 9, weiter umfassend:
- Durchführen der selektiven lonenimplantationen zur Formierung der HS-SIC-Dotierung und/oder der HV-SIC-Dotierung in selbstjustierter Weise zum Emitterfenster, wobei Gebiete außerhalb des Emitterfensters vom Isolatorschichtstapel (i4, i5, i6) vor der Implantation geschützt werden.

11. Verfahren nach Anspruch 1 bei dem die Siliziumdioxidschicht (i7) im Schritt g mittels eines Niederdruck-CVD Prozesses mit Hilfe eines Trägergases abgeschieden wird, das BIS(tert-Butylamino)Silan enthält.

12. Verfahren nach Anspruch 1, bei dem die Isolatorschichtfolge (i8, i9, i10, i11) als Schichtfolge von vier Einzelschichten aus Siliziumoxid (i8), Siliziumnitrid (i9), Siliziumoxid (i10) und Siliziumnitrid ausgeführt (i11) ist.

13. Verfahren nach einem der vorstehenden Ansprüche, umfassend, nach Herstellung der seitlichen Spacer (i12) an den Seitenflächen des Emitters und nach der Entfernung der Siliziumnitrid-Schicht (i5) und vor der Höhenerweiterung (exB) der Basisanschlussschicht:
- Durchführen einer Schrägwinkelimplantation mit Waferdrehung, um außerhalb der inneren Transistorgebiete oberflächennahe Regionen der Basis und der Cap-Schicht mit einer hohen Konzentration an Störstellen vom Leitfähigkeitstyp der Basis zu versehen.

14. BiCMOS-Halbleitervorrichtung umfassend Hochgeschwindigkeitsbipolartransistoren, nachfolgend HS-Transistoren, und Hochspannungs-Bipolartransistoren, nachfolgend HV-Transistoren, umfassend:
a. ein Substrat mit aktiven Gebieten und grabenförmigen flachen Feldisolationsgebieten, die die aktiven Gebiete lateral umschließen;
b1. in den für die HV-Transistoren vorgesehenen aktiven Gebieten jeweils ein zusammenhängendes hochleitfähiges HV-Kollektorgebiet eines ersten Leitfähigkeitstyps; und
b2. in den für die HS-Transistoren vorgesehenen aktiven Gebieten jeweils ein zusammenhängendes hochleitfähiges HS-Kollektorgebiet des ersten Leitfähigkeitstyps;
c1. eine erste selektive Kollektordotierung, nachfolgend HV-SIC-Dotierung, die auch in den HS-Transistorgebieten vorliegen kann, und
c2. eine zusätzliche zweite selektive Kollektordotierung, nachfolgend HS-SIC-Dotierung, die ausschließlich in den HS-Transistoren im jeweiligen inneren Transistorgebiet vorliegt, wobei die Dotierungen der Kollektorgebiete so gewählt sind, dass die vertikale Erstreckung der Basis-Kollektor-Raumladungszone im HV-Transistor größer als im HS-Transistor ist;
d. innerhalb des jeweils selben, von demselben Feldisolationsgebiet umschlossenen aktiven Gebiet, in dem der jeweilige Basisschichtstapel angeordnet ist, ein Kollektoranschlussgebiet, welches das Kollektorgebiet der HS-Transistoren und der HV-Transistoren mit einem Kollektorkontakt verbindet;
e. in einem von Isolatorschichten (i1, i2) umgrenzten Kollektorfenster der HV-Transistoren und der HS-Transistoren jeweils ein Basisschichtstapel, der eine epitaktische Pufferschicht (P), eine einkristalline, nicht-selektiv epitaktisch abgeschiedene Basisschicht (B) eines zweiten, dem ersten entgegengesetzten Leitfähigkeitstyps und eine einkristalline Cap-Schicht (C) aufweist, wobei aufgrund der nicht-selektiven epitaktischen Abscheidung der Basisschicht auf den Isolatorschichten (i1, i2) im Bereich der Basisschicht und der Capschicht ein zumindest an diese Schichten polykristallin anschließender Schichtstapel eines Basisanschlussgebiets angeordnet ist;
f. eingebettet in Basis-Emitter-Spacer (s1) und eine weitere Isolatorschicht (i6) der HV-Transistoren und der HS-Transistoren jeweils eine hoch dotierte, einkristalline oder polykristalline T-förmige Emitterschicht (E) des ersten Leitfähigkeitstyps und seitliche Spacer (i12) an nach außen weisenden Seitenflächen der Emitterschicht (E) und der weiteren Isolatorschicht (i6); und
g. außerhalb des Emitters der HV-Transistoren und der HS-Transistoren jeweils eine Höhenerweiterung (exB) der Basisanschlussschicht.

## Claims

1. Method for producing, in the context of carrying out a BiCMOS manufacturing process, high-speed bipolar transistors, hereinafter HS transistors, Case A, or HS transistors and high-voltage bipolar transistors, hereinafter HV transistors, Case AB, comprising:
a. providing a substrate with active regions and trench-shaped shallow field isolation regions enclosing the active regions;
b. subsequently:
b1. in Case AB: performing a masked first ion implantation to form a highly conductive HV collector region of a first conductivity type in the active regions provided for the HV transistors; and
b2. performing a masked second ion implantation to form a highly conductive HS collector region of the first conductivity type in the active regions provided for the HS transistors;
c. subsequently: depositing insulator layers (i1, i2, i3) on the substrate surface and defining collector windows as inner transistor regions of the HS and HV transistors;
d. subsequently: selective epitaxial deposition of a buffer layer (P) in the collector windows defined in this way, followed by non-selective epitaxial deposition of a single-crystalline base layer (B) of a second conductivity type opposite to the first and a single-crystalline cap layer (C) on the single-crystalline base layer (B), wherein during the non-selective epitaxial deposition, a polycrystalline layer stack grows simultaneously on the insulator layers (i1, i2), and wherein the deposition of the buffer layer (P), the base layer (B), and the cap layer (C) takes place in a common or in two separate epitaxy steps;
e. subsequently: depositing an insulator layer stack (i4, i5, i6) comprising three insulator layers over the cap layer (C) and subsequently defining an emitter window by opening a window in the insulator layers of the insulator layer stack;
f. performing ion implantations of the collector doping type to form, in Case A and AB, selectively implanted collector regions of the HS transistors, hereinafter HS-SIC doping, and, in Case AB, selectively implanted collector regions of the HV transistors, hereinafter HV-SIC doping, optionally after the deposition of the buffer layer (P) when performing the depositions in step d in two separate epitaxy steps or after opening the emitter windows in step e, comprising
f1. selective ion implantation into inner collector regions of the HS transistors, wherein the optionally provided HV transistors are protected by a resist mask or by the insulator stack (i4, i5, i6) before the implantation,
f2. in Case AB: selective ion implantation into inner collector regions of the HV transistors, wherein the HS transistors are optionally covered by a resist mask or also undergo this implantation of the inner collector regions,
f3. in Case AB: choice of implantation conditions of the HS-SIC doping and the HV-SIC doping such that a vertical extent of a base-collector space charge zone in the HV transistor is greater than in the HS transistor;
g. subsequently: depositing a silicon dioxide layer (i7) and forming base-emitter spacers (s1) within the emitter window by partially anisotropic etching back of the silicon dioxide layer (i7) using a dry etching process, and forming auxiliary spacers (sn) in the emitter window by depositing a silicon nitride layer and subsequent anisotropic etching back with a stop on the remaining part of the silicon dioxide layer (i7);
h. subsequently: exposing a surface formed by the cap layer in the emitter window and subsequent removal of the auxiliary spacers (sn);
i. subsequently: epitaxial deposition of a highly doped, single-crystalline or polycrystalline emitter layer (E) of the first conductivity type;
j. subsequently: depositing an insulator layer sequence (i8 to i11) and structuring the insulator layer sequence (i8 to i11), the emitter layer, and the insulator layer (i6) to form a T-shaped emitter, and producing lateral spacers (i12) on the outward-facing side surfaces of the emitter layer (E) and the insulator layer (i6);
k. subsequently: exposing the cap layer (C) in regions outside the emitter and selective epitaxy of a height extension of a base connection layer (exB) with in-situ doping of the conductivity type of the base (B); subsequently increasing the conductivity of the base connection layer by ion implantation; and
l. subsequently: removing, from collector connection regions, parts of the buffer, base, cap, and raised base connection layers which have been deposited on the base connection regions.

2. Method according to claim 1, wherein after the formation of the collector regions of the HV and/or HS transistors in step b, a silicon buffer layer is additionally selectively epitaxially deposited on the exposed collector regions.

3. Method according to claim 1, wherein the ion implantations of the collector regions of the HS-HBTs and the HV-HBTs are carried out such that a boundary of a collector-substrate space charge zone on its side closer to the substrate surface is formed less deeply in the substrate than a bottom of the field isolation regions.

4. Method according to any one of the preceding claims, wherein the crystal lattice of the Si substrate disturbed during the collector implantation is reconstructed with minimal defects by means of a heat treatment.

5. Method according to any one of the preceding claims, wherein the production of the isolation regions comprises firstly the deposition of a first SiO₂ layer (i1) and then a second SiO₂ layer (i2) that is more etch-stable against wet etching in diluted hydrofluoric acid, wherein
a) the ratio of the etching rates of the layers (i1) and (i2) is greater than 1.5, preferably greater than 2;
b) the layer (i1) is preferably produced by low-pressure CVD-TEOS and the layer (i2) is preferably produced by plasma-enhanced oxide deposition;
c) the layer (i2) is preferably thicker than the layer (i1).

6. Method according to claim 5, further comprising
- depositing a silicon nitride auxiliary layer (i3) on the second SiO₂ layer (i2) for the production of the inner transistor regions.

7. Method according to claim 6, wherein defining the collector windows of the HS and HV transistors comprises:
- removing the silicon nitride auxiliary layer (i3) and the second SiO₂ layer (i2) in the windows defined by means of a resist mask using one or more dry etching steps, wherein an etching time of the dry etching step is set such that an etching front is produced within the first SiO₂ layer (i1).

8. Method according to any one of the preceding claims, comprising:
- performing a short-time temperature treatment after depositing the insulator layer stack (i4, i5, i6) over the cap layer (C).

9. Method according to any one of the preceding claims, wherein defining the emitter window comprises:
- structuring a PECVD oxide layer (i6) of the insulator layer stack by dry etching, preferably under etching conditions that hardly or do not at all remove an adjacent silicon nitride layer (i5) of the insulator layer stack;
- further opening of the silicon nitride layer (i5), for example by an isotropic wet etching process to support an upward widening of the opening.

10. Method according to claim 9, further comprising:
- performing the selective ion implantations to form the HS-SIC doping and/or the HV-SIC doping in a self-aligned manner to the emitter window, wherein regions outside the emitter window are protected from the implantation by the insulator layer stack (i4, i5, i6).

11. Method according to claim 1, wherein the silicon dioxide layer (i7) is deposited in step g by a low-pressure CVD process using a carrier gas that contains BIS(tert-butylamino) silane.

12. Method according to claim 1, wherein the insulator layer sequence (i8, i9, i10, i11) is designed as a layer sequence of four individual layers of silicon oxide (i8), silicon nitride (i9), silicon oxide (i10) and silicon nitride (i11).

13. Method according to any one of the preceding claims, comprising, after production of the lateral spacers (i12) on the side surfaces of the emitter and after the removal of the silicon nitride layer (i5) and before the height extension (exB) of the base connection layer:
- performing an oblique angle implantation with wafer rotation to provide near-surface regions of the base and the cap layer outside the inner transistor regions with a high concentration of base conductivity type impurities.

14. BiCMOS semiconductor device comprising high-speed bipolar transistors, hereinafter HS transistors, and high-voltage bipolar transistors, hereinafter HV transistors, comprising:
a. a substrate with active regions and trench-shaped shallow field isolation regions that laterally enclose the active regions;
b1. in the active regions provided for the HV transistors, a contiguous highly conductive HV collector region of a first conductivity type; and
b2. in the active regions provided for the HS transistors, a contiguous highly conductive HS collector region of the first conductivity type;
c1. a first selective collector doping, hereinafter HV-SIC doping, which may also be present in the HS transistor regions, and
c2. an additional second selective collector doping, hereinafter HS-SIC doping, which is present exclusively in the HS transistors in the respective inner transistor region, wherein the dopings of the collector regions are chosen such that the vertical extent of the base-collector space charge zone in the HV transistor is greater than in the HS transistor;
d. within the same active region enclosed by the same field isolation region in which the respective base layer stack is arranged, a collector connector region which connects the collector region of the HS transistors and the HV transistors to a collector contact;
e. in a collector window of the HV transistors and the HS transistors, which is delimited by insulator layers (i1, i2), respectively a base layer stack which has an epitaxial buffer layer (P), a single-crystalline, non-selectively epitaxially deposited base layer (B) of a second conductivity type opposite to the first, and a single-crystalline cap layer (C), wherein due to the non-selective epitaxial deposition of the base layer on the insulator layers (i1, i2) in the region of the base layer and the cap layer, a layer stack of a base connection region is arranged that is at least polycrystallinely adjacent to these layers;
f. embedded in base-emitter spacers (s1) and a further insulator layer (i6) of the HV transistors and the HS transistors, respectively a highly doped, single-crystalline or polycrystalline T-shaped emitter layer (E) of the first conductivity type and lateral spacers (i12) on outward-facing side surfaces of the emitter layer (E) and the further insulator layer (i6); and
g. outside the emitter of the HV transistors and the HS transistors, respectively a height extension (exB) of the base connection layer.

## Revendications

1. Procédé de fabrication, dans le cadre d'un procédé de fabrication bipolaire ou BiCMOS, de transistors bipolaires rapides, ci-après transistors HS, cas A, ou de transistors HS et transistors bipolaires haute tension, ci-après transistors HV, cas AB, comprenant :
a. la fourniture d'un substrat ayant des régions actives et des régions d'isolation de champ peu profond en forme de tranchée entourant les régions actives ;
b. par la suite :
b1. dans le cas AB, la réalisation d'une première implantation ionique masquée pour former une région collectrice HV hautement conductrice d'un premier type de conductivité dans les régions actives prévues pour les transistors HV ; et
b2. la réalisation d'une deuxième implantation ionique masquée pour former une région collectrice HS hautement conductrice du premier type de conductivité dans les régions actives prévues pour les transistors HS ;
c. par la suite, le dépôt de couches isolantes (i1, i2, i3) sur la surface du substrat et définition de fenêtres collectrices comme régions de transistor internes des transistors HS et HV ;
d. par la suite, le dépôt épitaxial sélectif d'une couche tampon (P) dans les fenêtres collectrices ainsi définies, ainsi que sur la couche tampon, puis le dépôt épitaxial non sélectif d'une couche de base monocristalline (B) d'un deuxième type de conductivité opposé au premier et d'une couche de recouvrement monocristalline (C) sur la couche de base monocristalline (B), dans lequel, pendant le dépôt épitaxial non sélectif, un empilement de couches polycristallines croît simultanément sur les couches isolantes (i1, i2), et dans lequel le dépôt de la couche tampon (P), de la couche de base (B) et de la couche de recouvrement (C) s'effectue en une seule étape épitaxiale commune ou en deux étapes épitaxiales distinctes ;
e. par la suite, le dépôt d'un empilement de couches isolantes (i4, i5, i6) comprenant trois couches isolantes sur la couche de recouvrement (C) puis définition d'une zone émettrice par ouverture d'une fenêtre dans les couches isolantes de l'empilement de couches isolantes;
f. la réalisation d'implantations ioniques de type dopage collecteur pour former, dans le cas A et AB, des régions collectrices sélectivement implantées des transistors HS, puis dopage HS-SIC, et, dans le cas AB, des régions collectrices sélectivement implantées des transistors HV, puis dopage HV-SIC, éventuellement après le dépôt de la couche tampon (P) lors de la réalisation des dépôts à l'étape d. en deux étapes d'épitaxie distinctes ou après ouverture des fenêtres d'émetteur à l'étape e, comprenant
f1. l'implantation ionique sélective dans les régions collectrices internes des transistors HS, les transistors HV étant protégés par un masque formant réserve ou par la pile isolante (i4, i5, i6) avant l'implantation,
f2. dans le cas AB, l'implantation ionique sélective dans les régions collectrices internes des transistors HV, les transistors HS étant éventuellement recouverts d'un masque formant réserve ou subissant également cette implantation des régions collectrices internes,
f3. dans le cas AB, la sélection des conditions d'implantation du dopage HS-SIC et du dopage HV-SIC telles qu'une extension verticale de la région de charge d'espace base-collecteur dans le transistor HV soit plus grande que dans le transistor HS ;
g. par la suite, le dépôt d'une couche de dioxyde de silicium (i7) et formation d'espaceurs base-émetteur (s1) dans la fenêtre de l'émetteur par gravure en retrait partiellement anisotrope de la couche de dioxyde de silicium (i7) à l'aide d'un procédé de gravure sèche, et formation d'espaceurs auxiliaires (sn) dans la fenêtre de l'émetteur par dépôt d'une couche de nitrure de silicium et par gravure en retrait anisotrope ultérieure avec un arrêt sur la partie restante de la couche de dioxyde de silicium (i7) ;
h. par la suite, l'exposition de la surface formée par la couche de recouvrement dans la fenêtre de l'émetteur et retrait ultérieur des espaceurs auxiliaires (sn) ;
i. par la suite, le dépôt épitaxial d'une couche émettrice (E) monocristalline ou polycristalline hautement dopée du premier type de conductivité ;
j. par la suite, le dépôt d'une séquence de couches isolantes (i8 à i11) et structuration de la séquence de couches isolantes (i8 à i11), de la couche émettrice et de la couche isolante (i6) pour former un émetteur en forme de T, et production d'espaceurs latéraux (i12) sur les surfaces latérales tournées vers l'extérieur de la couche émettrice (E) et de la couche isolante (i6) ;
k. par la suite, l'exposition de la couche de recouvrement (C) dans des zones situées à l'extérieur de l'émetteur et épitaxier sélectivement une extension en hauteur (exB) d'une couche de connexion de base (exB) avec dopage in situ du type de conduction de la base (B) ; par la suite, l'augmentation de la conductivité de la couche de connexion de base par implantation ionique ; et
l. par la suite, enlèvement, des parties de la couche de connexion tampon, base, recouvrement et base surélevée déposées sur les régions de connexion de base des régions de connexion de collecteur.

2. Procédé selon la revendication 1, dans lequel, après la formation des régions collectrices des transistors HV et/ou HS à l'étape b, une couche tampon en silicium est en outre déposée de manière épitaxiale sélective sur les régions collectrices exposées.

3. Procédé selon la revendication 1, dans lequel les implantations ioniques des régions collectrices des HS-HBT et des HV-HBT sont réalisées de telle sorte qu'une limite d'une zone de charge d'espace collecteur-substrat sur son côté le plus proche de la surface du substrat est formée moins profondément dans le substrat qu'un fond des régions d'isolation de champ.

4. Procédé selon l'une des revendications précédentes, dans lequel le réseau cristallin du substrat Si perturbé lors de l'implantation du collecteur est reconstruit avec peu de défauts au moyen d'un traitement thermique.

5. Procédé selon l'une des revendications précédentes, dans lequel la réalisation des zones d'isolation comprend le dépôt d'une première couche de SiO₂ (i1) puis une deuxième couche de SiO₂ qui est plus stable que la gravure humide dans l'acide fluorhydrique dilué (i2), dans lequel
a) le rapport des vitesses de gravure des couches (i1) et (i2) est supérieur à 1,5, de préférence supérieur à 2 ;
b) la couche (i1) est de préférence produite au moyen de CVD-TEOS basse pression et la couche (i2) est de préférence produite au moyen d'un dépôt d'oxyde assisté par plasma ;
c) la couche (i2) est de préférence plus épaisse que la couche (i1).

6. Procédé selon la revendication 5, comprenant en outre
- le dépôt d'une couche auxiliaire de nitrure de silicium (i3) sur la deuxième couche de SiO₂ (i2) pour la réalisation des régions internes du transistor.

7. Procédé selon la revendication 6, dans lequel la définition des fenêtres collectrices des transistors HS et HV comprend :
- le retrait de la couche auxiliaire de nitrure de silicium (i3) et de la deuxième couche de SiO₂ (i2) dans les fenêtres définies au moyen d'un masque formant réserve à l'aide d'une ou plusieurs étapes de gravure sèche, dans lequel un temps de gravure de l'étape de gravure sèche est réglé de telle sorte qu'un front de gravure soit produit dans la première couche de SiO₂ (i1).

8. Procédé selon l'une des revendications précédentes, comprenant l'étape consistant à :
- effectuer un traitement thermique de courte durée après dépôt de l'empilement de couches isolantes (i4, i5, i6) sur la couche de recouvrement (C).

9. Procédé selon l'une quelconque des revendications précédentes, dans lequel la définition de la fenêtre d'émetteur comprend :
- la structuration d'une couche d'oxyde PECVD (i6) de l'empilement de couches isolantes par gravure sèche, de préférence dans des conditions de gravure qui éliminent à peine ou pas du tout une couche adjacente de nitrure de silicium (i5) de l'empilement de couches isolantes ;
- l'ouverture supplémentaire de la couche de nitrure de silicium (i5), par exemple par un procédé de gravure humide isotrope pour favoriser un élargissement vers le haut de l'ouverture.

10. Procédé selon la revendication 9, comprenant en outre l'étape consistant à :
- réaliser les implantations ioniques sélectives pour former le dopage HS-SIC et/ou le dopage HV-SIC de manière auto-alignée sur la fenêtre émettrice, les régions situées à l'extérieur de la fenêtre émettrice étant protégées de l'implantation par l'empilement de couches isolantes (i4, i5, i6).

11. Procédé selon la revendication 1, dans lequel la couche de dioxyde de silicium (i7) est déposée à l'étape g au moyen d'un procédé CVD basse pression à l'aide d'un gaz vecteur contenant du BIS(tert-butylamino)silane.

12. Procédé selon la revendication 1, dans lequel la séquence de couches isolantes (i8, i9, i10, i11) est conçue comme une séquence de couches de quatre couches individuelles d'oxyde de silicium (i8), de nitrure de silicium (i9), d'oxyde de silicium (i10) et de nitrure de silicium (i11).

13. Procédé selon l'une des revendications précédentes, comprenant, après réalisation des espaceurs latéraux (i12) sur les surfaces latérales de l'émetteur et après élimination de la couche de nitrure de silicium (i5) et avant l'extension en hauteur (exB) de la couche de connexion de base :
- la réalisation d'une implantation à angle oblique avec rotation de la plaquette pour fournir des régions proches de la surface de la couche de base et de recouvrement à l'extérieur des régions internes du transistor avec une concentration élevée d'impuretés de type conductivité de base.

14. Dispositif semi-conducteur BiCMOS comprenant des transistors bipolaires à grande vitesse, ci-après transistors HS, et des transistors bipolaires à haute tension, ci-après transistors HV, comprenant :
a. un substrat ayant des régions actives et des régions d'isolation de champ peu profond en forme de tranchée entourant latéralement les régions actives;
b1. dans les régions actives prévues pour les transistors HV, une région collectrice HV contiguë hautement conductrice d'un premier type de conductivité ; et
b2. dans les régions actives prévues pour les transistors HS, une région collectrice HS contiguë hautement conductrice du premier type de conductivité ;
c1. un premier dopage sélectif du collecteur, puis un dopage HV-SIC, qui peut également être présent dans les régions des transistors HS, et
c2. un deuxième dopage sélectif supplémentaire du collecteur, ci-après dopage HS-SIC, qui est présent exclusivement dans les transistors HS dans la région de transistor interne respective, les dopages des régions de collecteur étant sélectionnés de telle sorte que l'extension verticale de la zone de charge d'espace base-collecteur dans le transistor HV soit supérieure à celle du transistor HS ;
d. dans la même région active entourée par la même région d'isolation de champ dans laquelle est disposée la pile de couches de base respective, une région de connexion de collecteur qui relie la région de collecteur des transistors HS et des transistors HV à un contact de collecteur ;
e. dans une fenêtre collectrice des transistors HV et des transistors HS, qui est bordée par des couches isolantes (i1, i2), se trouve dans chaque cas un empilement de couches de base qui comporte une couche tampon épitaxiale (P), une couche de base monocristalline, déposée par épitaxie non sélective (B) d'un deuxième type de conductivité opposé au premier, et une couche de recouvrement monocristalline (C), dans lequel, en raison du dépôt épitaxial non sélectif de la couche de base sur les couches isolantes (i1, i2), un empilement de couches d'une région de connexion de base qui est polycristalline et jouxte au moins ces couches est disposé dans la région de la couche de base et de la couche de recouvrement ;
f. intégré dans des espaceurs base-émetteur (s1) et une autre couche isolante (i6) des transistors HV et des transistors HS, une couche émettrice en forme de T (E) monocristalline ou polycristalline hautement dopée du premier type de conductivité et des espaceurs latéraux (i12) sur les surfaces latérales tournées vers l'extérieur de la couche émettrice (E) et de l'autre couche isolante (i6) ; et
g. à l'extérieur de l'émetteur des transistors HV et des transistors HS, dans chaque cas, une extension en hauteur (exB) de la couche de connexion de base.
